# EUROPEAN PATENT SPECIFICATION

(11) **EP 4 260 121 B1**
(45) Date of publication and mention of the grant of the patent: **29.10.2025**
(21) Application number: 21811329.8
(22) Date of filing: 15.11.2021
(51) Int. Cl.: G03F 7/00, G02B 5/08, G02B 5/09, G02B 26/08, G02B 26/12

(54) **MICROMIRROR ARRAYS**
MIKROSPIEGELARRAYS
RÉSEAUX DE MICROMIROIRS

(30) Priority: 14.12.2020 EP 20213672
(43) Date of publication of application: 18.10.2023
(73) Proprietor: ASML Netherlands B.V., 5500 AH Veldhoven (NL)
(72) Inventor: AKBULUT, Duygu, 5500 AH Eindhoven (NL); HASPESLAGH, Luc, Roger, Simonne, 3001 Linden (BE); PANDEY, Nitesh, 5500 AH Eindhoven (NL); VAN DER WOORD, Ties, Wouter, 5500 AH Eindhoven (NL); BRONDANI TORRI, Guilherme, 3001 Leuven (BE); GOORDEN, Sebastianus, Adrianus, 5500 AH Eindhoven (NL); KLEIN, Alexander, Ludwig, 5500 AH Eindhoven (NL); OVERKAMP, Jim, Vincent, 5500 AH Eindhoven (NL); YEGEN, Halil, Gökay YEGEN, 5500 AH Eindhoven (NL); OSORIO OLIVEROS, Edgar, Alberto, 5500 AH Eindhoven (NL)
(74) Representative: ASML Netherlands B.V.
(86) International application number: PCT/EP2021/081686
(87) International publication number: WO 2022/128284

(56) References cited:
- EP-A1- 3 639 967
- WO-A1-2016/146541
- DE-A1- 102008 049 556
- DE-A1- 102013 206 529

## Description

### CROSS-REFERENCE TO RELATED APPLICATIONS

This application claims priority of EP application 20213672.7 which was filed on December 14, 2020.

### FIELD

The present invention relates to a micromirror array, a programmable illuminator comprising such a micromirror array, a lithographic apparatus comprising such a programmable illuminator, an inspection and/or metrology apparatus comprising such a programmable illuminator and a method for forming such a micromirror array.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device onto a layer of radiation-sensitive material (resist) provided on a substrate. The term "patterning device" as employed in this text should be broadly interpreted as referring to a device that can be used to endow an incoming radiation beam with a patterned cross-section, corresponding to a pattern that is to be created in a target portion of the substrate; the term "light valve" can also be used in this context. Generally, the pattern will correspond to a particular functional layer in a device being created in the target portion, such as an integrated circuit or other device. Examples of such patterning devices include:
- A mask (or reticle). The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. The mask may be supported by a support structure such as a mask table or mask clamp. This support structure ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such a device is that (for example) addressed areas of the reflective surface reflect incident light as diffracted light, whereas unaddressed areas reflect incident light as undiffracted light. Using an appropriate filter, the undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis, for example by applying a suitable localized electric field, or by employing electrostatic or piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. a programmable mirror array may be supported by a support structure such as a frame or table, for example, which may be fixed or movable as required; and
- A programmable LCD array. An example of such a construction is given in United States Patent US 5,229872. Such a programmable LCD array may be supported by a support structure such as a frame or table, for example, which may be fixed or movable as required.

For purposes of simplicity, the rest of this text may, at certain locations, specifically direct itself to examples involving a mask and a mask table; however, the general principles discussed in such instances should be seen in the broader context of the patterning means as hereabove set forth.

To project a pattern on a substrate a lithographic apparatus may use electromagnetic radiation (here referred to often as simply "light", though the wavelength may not be in the visible range). The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Besides the wavelength (λ) of the radiation and the Numerical Aperture (NA) of the projection lens, the shape, or more generally the angular intensity distribution, of the illumination source is one of the most important parameters in enabling high resolution in lithography.

A micromirror array, comprising an array of hundreds or thousands of micromirrors (often referred to below simply as "mirrors"), can be used in the illumination system of a lithographic apparatus to control the cross-sectional shape and intensity distribution of the light. Each micromirror reflects a spot of light and changing the angles of the micromirrors changes the positions of the spots and thus changes the shape of the radiation beam.

Microelectromechanical systems (MEMS) technology may be used to manufacture and control the mirrors. For example, an electrostatic or piezoelectric MEMS system may be used to angle the mirrors.

Currently micromirror arrays exist for shaping light having a wavelength in the deep ultraviolet spectrum (DUV), e.g. λ = 193 nm. However, these micromirror arrays cannot be effectively used at shorter wavelengths as required for light in the extreme ultraviolet spectrum (EUV), e.g. λ = 13.5 nm. New micromirror array technology is required for use with EUV radiation. Also, advantageous new applications for this new micromirror array technology are desired, for use with EUV and/or non-EUV radiation, e.g. visible light or DUV radiation.

PCT patent application PCT/EP2020/072005 (which was not published at the priority date of the present application) discloses a micromirror array that comprises a heat diffuser comprising a heat sink formed by a flexible membrane. The purpose of the heat diffuser is to conduct heat generated by the EUV illumination away from the mirror to the substrate, so a high thermal conductivity of the heat sink is required. As the mirror is designed to have its position adjusted, the heat sink must also be sufficiently flexible in order not to restrict the movement of the mirror. Increasing the thickness of the heat sink would improve its thermal conductance. However, increasing the thickness of the heat sink reduces its flexibility.

PCT patent application PCT/EP2020/072005 also discloses a micromirror array that comprises a plurality of actuators used to adjust the tilt of respective mirrors forming part of the micromirror array. The application further discloses a series of piezoelectric sensor elements to determine the degree by which the mirrors are displaced by the actuators. However, the temperature dependence of piezoresistive sensing can cause irregularities in position measurement.

DE 10 2013 206529 A1 relates to a micro actuator, to a method for producing a micro actuator and to a facet mirror for an illumination optical unit of a projection exposure apparatus.

### SUMMARY

The present invention relates to a micromirror array according to claim 1 and to a corresponding method of forming the latter which are explained

According to a first expression of the invention there is provided a micromirror array being a microelectromechanical system (MEMS) comprising a heat diffuser that, for example, may be used in the illumination system of a lithographic apparatus or an inspection and/or metrology apparatus to condition a radiation beam. According to claim 1 the micromirror array comprises a substrate and a plurality of mirrors for reflecting incident light. For each mirror, there is at least one actuator for displacing the mirror connected to the substrate, and one or more pillars connecting the (or each) actuator to the mirror. The pillar(s) is (are) operative to support the mirror from the actuator(s). The actuator can move the pillar and thereby displace the mirror, in order to change the angle of the mirror and thereby change the shape of the radiation beam. The actuator may be a piezoelectric actuator. Applying a voltage to the piezoelectric actuator can cause the actuator to move the pillar and thereby displace the mirror, in order to change the angle of the mirror and thereby change the shape of the radiation beam. Preferably, the micromirror array includes four actuators for each mirror, arranged so as to enable tip and tilt displacement control of the mirror.

According to claim 1 the micromirror array also comprises, for each mirror in the array, a heat diffuser for diffusing heat from the mirror. In use, the micromirror array will absorb some energy from the incident light, which increases the temperature of the device. This increase in temperature can decrease device performance. Typically, the micromirror array is intended to operate in an environment with a gas pressure far less than one atmosphere, in fact typically substantially in a vacuum, so heat convection is substantially zero. Instead, the heat diffuser allows heat to be conducted away, such as to the substrate. The heat diffuser comprises a flexible member, in the form of a flexible membrane, connected between the mirror and the substrate and arranged to flex as the mirror is moved. There is a trade-off between increased flexibility of the heat diffuser, and increased ability for the heat diffuser to conduct heat away from the mirror. Using piezoelectric actuator(s) allows increased force to be applied to the flexible member, in turn allowing the heat diffuser to be selected to provide improved thermal conductivity.

According to claim 1 the heat diffuser comprises a heat sink and a thermally conductive post connecting the heat sink to the mirror. The thermally conductive post may be connected to a central portion of the heat sink. According to claim 1 the heat sink comprises the flexible membrane, which allows the post to pivot when the mirror is displaced, and the central post may be connected to a central portion of the flexible membrane. The flexible membrane can be a patterned silicon layer, which has the advantage of being readily available in a CMOS manufacturing process, without requiring further masks or process steps. The flexible membrane can comprise grooves through the flexible membrane and extending from an outer edge of the heat sink towards the thermally conductive post. The grooves, which may be curved grooves, increase the flexibility of the membrane so as to not impede motion of the mirror. Piezoelectric actuators of preferred embodiments are selected to provide a level of force which is greater than the electrostatic actuators used in some conventional systems, and which is sufficient to deform the flexible membrane even though it has sufficient cross-sectional area (for example, as measured at the intersection of the flexible membrane with a circular-cylindrical surface transverse to the flexible member and with an axis coinciding with an axis of the thermally conductive post) to permit greater heat diffusion than that provided for conventional mirror arrays. This allows the present micromirror array to be used in applications for which the conventional mirror arrays would be unsuitable.

If the flexible member has a constant thickness, as in PCT/EP2020/072005, the area of the intersection of the flexible membrane with a circular-cylindrical surface transverse to the flexible membrane and with an axis coinciding with an axis of the thermally conductive post, is proportional to the radius of the cylinder. In other words, the ring-shaped element of the flexible member at this intersection has a thermal resistance in relation to heat passing radially outward through the element which is inversely proportional to the radius of the cylinder. In other words, the ability of the element of the flexible membrane to conduct heat away from the central thermally conductive post is proportional to the radius of the cylinder. Thus, a central portion of the heat sink is less effective than a peripheral portion at conducting the heat generated at the mirror towards the substrate, resulting in the heat sink as a whole functioning less efficiently, and the mirror reaching a higher temperature in use. The thermal resistance of the flexible member could be reduced by increasing the thickness of the flexible mirror, but this would reduce the flexibility of the flexible member.

To address the above problem, according to the first aspect of the present invention, the flexible member is formed to be thicker near its center than at a peripheral portion of the flexible member. A peripheral portion of a flexible member according to the first aspect of the invention has a smaller thickness than the peripheral portion of a flexible member of uniform thickness having the same ability to conduct heat from the thermally conductive post. Generally speaking the stiffness of any given region of the flexible member towards torsion is proportional to its smallest dimension to the power of three, and linearly proportional to its largest dimension. Thus, in the peripheral portion, where the thickness of the flexible member is the smallest dimension, the stiffness is proportional to the thickness of the flexible member in that region raised to the power of three, so a small proportional reduction in the thickness of the peripheral portion of the flexible member causes a large increase in the flexibility of that peripheral portion. It is true that towards its center, the flexible member of variable thickness would have a greater thickness than a diffuser of uniform thickness having the same overall thermal resistance. However, this portion of the flexible membrane is less significant in determining the overall flexibility of the flexible member. In particular, the torsional stiffness of any region of the flexible membrane which is thicker than the distance of the region from the center of the heat sink is only linearly dependent on the thickness of the region. Overall, due to its outer portions, the variable thickness flexible member is more flexible both for torsion and deflection than a constant thickness flexible member having the same overall thermal resistance. Even the central portion of the variable thickness flexible member is flexible to some extent.

The thickness of the flexible membrane at a given point may be substantially proportional to 1 divided by the distance of the point to the center of the flexible membrane. This means that the thermal resistivity of the flexible membrane at any distance from the center of the flexible membrane is uniform, and in use a linear dependence is obtained of temperature on distance from the center of the heat sink.

In principle, the change in the thickness of the flexible membrane may be continuous from the center of the flexible membrane to the periphery of the flexible membrane. Alternatively, the flexible membrane may comprise Z portions, where each portion z may be of uniform thickness. For any value of z from 1 to Z-1: portion z + 1 may encircle portion z; and portion z + 1 may have a thickness less than a thickness of portion z. The portion z = 1 may be called the center portion of the flexible membrane, and the portion z = Z may be called the peripheral portion. Each portion of the flexible membrane (i.e. each value of z), has a corresponding average distance R(z) from the center of the flexible membrane. This average may be calculated as the average of the distances of the radially-inner and radially outer edges of portion z from the center of the flexible membrane. The thickness of the flexible membrane in portion z may be chosen to be substantially proportional to 1/R(z).

The heat sink may comprise a layer of metal, such as aluminum, which has a relatively high thermal conductivity compared to e.g. silicon. The thermally conductive post may also be electrically conductive and connected to ground, so as to prevent charge build up on the mirror, which may otherwise impede displacement control of the mirror.

The piezoelectric actuators may comprise a strip of flexible material connected at one end to the substrate, with the pillar being located at the opposite end of the strip of flexible material, and a layer of piezoelectric material provided on the strip of flexible material. The strip and the layer of piezoelectric material may thereby form a cantilever, anchored to the substrate at one (fixed relative to the substrate) end and connected to the mirror via the pillar at the opposite (moving) end. By applying a voltage to the layer of piezoelectric material, the layer can expand or contract and thereby stress the strip and cause it to bend. Each piezoelectric actuator may also comprise a hinge connected to an end of the strip and to the pillar. The hinge has a smaller cross section than the strip in the elongation direction of the strip (i.e. the cross section looking end-on at the strip). For example, the hinge may be formed from the same material as the strip of flexible material (typically silicon), but be patterned to have a smaller cross section to increase its flexibility and thereby cause it to act as a hinge between the strip and the pillar. The reduced cross-sectional area can also decrease the thermal conductivity of the hinge compared to the strip of flexible material, which may therefore be advantageous in preventing heating of the piezoelectric actuator. The pillar may comprise a thermally isolating layer (e.g. oxide) to reduce or prevent heat transfer from the mirror to the piezoelectric actuator. The pillar may also be configured to electrically isolate the mirror from the piezoelectric actuator. This may prevent charge build up on the mirror from affecting the piezoelectric actuator.

The micromirror array may further comprise, for each mirror in the array, a sensing element for sensing displacement of the mirror. The sensing element can allow accurate determination of the mirror position (e.g. tip and tilt angles), which may be important for providing feedback to the piezoelectric actuators. The sensing element may be connected to the piezoelectric actuator. For example, the sensing element may comprise a piezoresistor arranged so that displacement of the mirror causes the piezoresistor to deflect (that is, be deformed). The piezoresistor may have one (fixed) end connected to the substrate and another (moving) end connected to one of the mirror, the pillar, and the piezoelectric actuator. The voltage output from the piezoresistor may be proportional to the displacement of the mirror.

Alternatively, in a second aspect of the present invention, the sensing element may be an evanescent coupling based tilt sensor. For each mirror, each corresponding evanescent coupling based tilt sensor may comprise first and second sensor elements respectively connected to the substrate and the mirror, and having a spacing which varies according to the displacement of the mirror relative to the substrate. One of the first sensor element and the second sensor element may include a light source, a waveguide, and a light detector. The sensor element including a light source, a waveguide, and a light detector may be the first sensor element. The light source is configured to transmit light into the waveguide, and the waveguide is configured to transmit the light to the light detector along a light path including at least one internal reflection within the waveguide. The light detector is positioned to detect the light that is transmitted through the waveguide. If the one of the first and second sensor elements that does not comprise the light source, waveguide, and light detector, is not sufficiently close to the waveguide, the light from the light source may undergo total internal reflection within the waveguide. However, if first and second sensor elements are sufficiently close, evanescent coupling may occur, resulting in some of the light from the light source not undergoing internal reflection, and thus in less light being detected at the light detector. The proportion of light which is reflected at the internal reflection depends upon the spacing of the first and second sensor elements.

The second sensor element may be positioned on a surface of the mirror facing towards the substrate. Indeed, the second sensor element may be a surface portion of the mirror facing towards the substrate. This surface may be on the side of the mirror opposite the reflective surface of the mirror. The surface of the mirror facing towards the substrate may be rectangular ("rectangular" in this document is used to include square), and the second sensor element may be positioned proximate a corner of this rectangular surface (e.g. spaced from each of two adjacent sides of the rectangular surface by no more than 20% of the distance from each of those sides to a respective opposing side of the rectangular surface). There may be one evanescent coupling based tilt sensor provided at each corner of the surface of the mirror facing the substrate.

As described above, each mirror may be connected to the substrate by a flexible member which permits the mirror to pivot relative to the substrate about a corresponding fulcrum. The micromirror array according to the second aspect of the invention may further comprise for each mirror at least one third sensor element connected to the substrate, wherein the third and second sensor element have a spacing which varies according to the displacement of the mirror relative to the substrate. The third sensor element may include an additional light source, an additional waveguide, and an additional light detector. The additional light source is configured to transmit light into the additional waveguide, and the additional waveguide is configured to transmit the light to the additional light detector along a light path including at least one internal reflection within the additional waveguide. If the second sensor element is not sufficiently close to the waveguide, the light from the light source may undergo total internal reflection within the waveguide. However, if the second sensor element is sufficiently close the waveguide, evanescent coupling may occur, resulting in some of the light from the light source not undergoing internal reflection within the waveguide, and thus in less light being detected at the light detector. The proportion of light which is reflected at the internal reflection thus depends upon the spacing of the second and third sensor elements.

The third sensor element may be closer to the fulcrum than the first sensor element, and, when a reflective surface of the mirror is parallel to a plane of the substrate, the third sensor element may be closer than the first sensor element to the second sensor element (that is, in a direction from the substrate towards the mirrors). The third sensor element may be useful for measuring the position of the mirror at a time when the mirror is nearly parallel to a plane of the substrate, and the second sensor element is so far from the first sensor element that there is little or no evanescent coupling between them, and thus the first sensor element cannot be used to determine the position of the mirror.

In either aspect of the invention, each mirror in the array is preferably suitable for reflecting light having a wavelength in the range of about 13nm, such as a narrow range centered substantially on 13.5nm. This enables the micromirror to be used with a lithographic apparatus operating in the extreme ultraviolet (EUV) spectrum.

According to a second expression of the present invention there is provided a programmable illuminator that comprises a micromirror array according to either the first aspect or the second aspect of the present invention for conditioning a radiation beam.

The programmable illuminator may further comprise a displacement control feedback system configured to determine for each mirror in the micromirror array a position of the mirror and to adjust a voltage applied to the associated piezoelectric actuators based on the determined position and based on a predefined target position of the mirror. The performance of the piezoelectric actuators may change over time, so that the initial calibration of displacement to applied voltage is no longer valid, and the displacement control feedback system can be used to adapt applied voltage based on the measured mirror position. The feedback system may comprise or make use of the sensing element of the micromirror array to determine the mirror position.

According to a third expression of the present invention there is provided a lithographic apparatus arranged to project a pattern from a patterning device onto a substrate. The lithographic apparatus comprises a programmable illuminator according to the second expression of the present invention for conditioning a radiation beam used to illuminate the patterning device and/or for conditioning a radiation beam used to measure a target structure on the substrate. The micromirror array in the programmable illuminator may be used in an illumination system of a lithographic apparatus for example to control or condition a cross-sectional shape and/or intensity distribution of the light or radiation beam that is used to illuminate the patterning device. Alternatively or in addition, the micromirror array in the programmable illuminator may be used in an alignment system and/or overlay measurement system, respectively, of the lithographic apparatus to control or condition a spectral and/or spatial distribution of the light or radiation beam that is used to measure a position of an alignment mark(er) or target structure on the substrate and/or to perform an overlay measurement of a mark(er) of target structure on the substrate, respectively.

According to a fourth expression of the present invention there is provided an inspection and/or metrology apparatus that comprises a programmable illuminator according to the second expression of the present invention for conditioning a radiation beam used to measure a target structure on a substrate. For example, the micromirror array in the programmable illuminator may be used to control or condition a spectral and/or spatial distribution of the light or radiation beam that is used by the inspection and/or metrology apparatus to measure a target structure, e.g. a mark(er), on the substrate in order to determine the position of that target structure for alignment purposes and/or in order to perform an overlay measurement.

According to claim 13 of the present invention there is provided a method of forming a micromirror array. The method may be used to form a micromirror array according to the first aspect and/or the second aspect of the present invention. The method of forming a micromirror array comprises: providing a substrate, forming a plurality of mirrors for reflecting incident light and for each mirror in the array, forming at least one actuator for displacing the mirror and connected to the substrate. The method further comprises forming one or more pillars for connecting the mirror to the at least one actuator.

The method may comprise forming a heat diffuser for diffusing heat from the mirror by forming a heat sink and a thermally conductive post connected to the mirror, wherein said step of bonding causes the thermally conductive post to connect to the heat sink. The step of forming the heat sink may comprise forming a flexible membrane, which allows the thermally conductive post to pivot when the mirror is displaced. The flexible membrane can be formed by patterning a silicon layer. The step of patterning the silicon layer may comprise forming grooves through the silicon layer that extend from an outer edge of the heat diffuser towards the thermally conductive post. The grooves may be curved grooves.

According to claim 1 the invention, the flexible membrane comprises a center portion and a peripheral portion, the center portion being connected to the thermally conductive post and having a thickness greater than a thickness of the peripheral portion.

The step of forming the heat sink may, according to the first aspect of the invention, comprise providing a laminar layer, and forming Z portions of the flexible membrane (where Z is at least two, and preferably at least three) by performing n etching steps on the laminar layer, and in each etching step removing a different respective thickness of material from a corresponding etched area of the flexible membrane. For example, labelling the n etching steps by j=1,...n (which is not necessarily the order in which the etching steps are performed), the thickness of material etched in step j may be proportional to 2^{j}. Each of the Z portions is etched during a different respective sub-set of the etching steps, and thus has a different respective final thickness. The number of portions Z may be up to 2ⁿ.

The method may further comprise, for each mirror in the array, forming at least one sensing element connected to the at least one actuator for sensing displacement of the mirror. The step of forming the sensing element may comprise forming a piezoresistor arranged so that displacement of the mirror causes the piezoresistor to deflect.

According to the second aspect of the invention, the method may further comprise forming an evanescent coupling based tilt sensor. The step of forming the evanescent coupling based tilt sensor may comprise forming a first sensor element on a surface of the substrate, and a second sensor element on a surface of the mirror.

In either aspect of the invention, the step of forming the actuator may comprise forming a strip of flexible material connected at one end to the substrate and a layer of piezoelectric material provided on the strip of flexible material.

The step of forming the pillar may comprise providing a thermally isolating layer in the pillar to reduce or prevent heat transfer from the mirror to the actuator.

The step of forming at least one actuator for each mirror may include forming four actuators, and said step of forming at least one pillar then includes forming four pillars connected to the mirror, wherein said step of bonding causes each of the four pillars to connect to a respective actuator of the four actuators.

Apart from the micromirror array, the microelectromechanical system (MEMS) may be used in other parts of a lithographic apparatus and/or an inspection and/or metrology apparatus. For example, the MEMS may be used with a single (macro) mirror by locating the plurality of MEMS elements underneath and deforming the mirror surface. Accordingly, the MEMS may further comprise a continuous reflective layer, wherein displacement of the MEMS elements causes the continuous reflective layer to be deformed in order to redirect light incident on the continuous reflective layer. The reflective layer can be a multilayer reflector, for example when used in a patterning device or in a normal incidence mirror, or may be a single metal foil, for example when used in a grazing incidence mirror.

The MEMS elements can in some instances be directly bonded to the continuous reflective layer or to a continuous substrate on which the continuous reflective layer is located (for example, the pillars directly attached to the actuators can be directly bonded to the back of the reflective layer). Alternatively, each MEMS element may comprise a displacement structure for supporting the continuous reflective layer and for translating displacements of the one or more actuators to the continuous reflective layer. The displacement structure may be formed in a separate wafer and bonded to the other part of the MEMS. The displacement structure may be a rectangular layer or block, which is tipped and tilted when displaced by the actuators. Other shapes of the displacement structure are also of course possible (e.g. hexagonal in the horizontal plane), depending on the type of deformation of the overlying structure that is required.

According to the first aspect of the present invention there is provided a microelectromechanical system (MEMS). The MEMS comprises a substrate, a plurality of MEMS elements (e.g. mirrors), and for each MEMS element of the plurality of MEMS elements, at least one actuator for displacing the MEMS element and connected to the substrate. The MEMS further comprises one or more pillars connecting the MEMS element to the at least one actuator, and, for each MEMS element of the plurality of MEMS elements, a heat diffuser for diffusing heat from the MEMS element, the heat diffuser comprising a heat sink and a thermally conductive post connecting the heat sink to the MEMS element, wherein the heat sink comprises a flexible membrane, which allows the thermally conductive post to pivot when the mirror is displaced. The flexible membrane comprises a center portion and a peripheral portion, the center portion being connected to the thermally conductive post and having a thickness greater than a thickness of the peripheral portion.

According to the second aspect of the invention there is provided a microelectromechanical system, MEMS. The MEMS comprises a substrate, a plurality of MEMS elements, and for each MEMS element of the plurality of MEMS elements, at least one actuator for displacing the MEMS element and connected to the substrate. The MEMS further comprises one or more pillars connecting the MEMS element to the at least one actuator, and for each MEMS element of the plurality of MEMS elements, at least one sensing element for sensing displacement of the MEMS element, wherein the at least one sensing element comprises an evanescent coupling based tilt sensor.

According to a sixth expression of the present invention there is provided a lithographic apparatus arranged to operate in a dark-field imaging mode when projecting a pattern from a patterning device onto a substrate. The apparatus comprises a patterning device (which may alternatively be referred to as a mask or a reticle) comprising a first MEMS according to the first or second aspect of the invention, wherein the first MEMS comprises a continuous reflective layer such as a multilayer reflector provided with a pattern for patterning the incident radiation beam. The apparatus further comprises a mirror for projecting the pattern from the patterning device and comprising a second MEMS according to the first or second aspect (e.g. a micromirror array), wherein the mirror comprises an opening arranged to let through the radiation beam used to illuminate the patterning device. The opening allows the radiation beam to have normal incidence on the patterning device. The first MEMS is configured to redirect a first order diffraction from the patterning device, which would otherwise fall inside the opening, and onto the mirror. The second MEMS is configured to compensate for the redirection so as to correct the projected pattern. The diffraction angle at any one point on the patterning device depends on the density or pitch of features of the patterning device at that point. A large pitch gives a small diffraction angle and requires a larger deformation of the surface of the patterning device to redirect the first order diffraction onto the mirror. The first MEMS can be pre-set to provide the appropriate local deformation across the patterning device and may then remain fixed throughout the patterning/scanning process. The second MEMS (i.e. the MEMS on the projection mirror) needs to dynamically update the displacements of the MEMS elements as the radiation beam is scanned across the patterning device in order to correctly compensate for the local deformation of the patterning device where the radiation beam is incident.

According to a seventh expression of the present invention there is provided a mask assembly, comprising a pellicle (a thin film) arranged to protect a surface of a patterning device from contamination, and a pellicle frame configured to support the pellicle and configured to fix the pellicle relative to the patterning device. The frame comprises a MEMS according to the first or second aspect of the invention, and the MEMS is configured to displace part of the pellicle so as to apply stress to the pellicle. The MEMS can displace a border area/portion of the pellicle to increase the stress, which can prevent the film from slacking and requiring replacement thereby prolonging the lifetime of the pellicle and mask assembly. Sensors in the MEMS elements can be used to determine the stress in the pellicle, and the MEMS elements can be individually controlled to apply stress locally across different sections of the pellicle.

According to an eighth expression of the present invention, there is provided a lithographic apparatus arranged to project a pattern from a patterning device onto a substrate, the lithographic apparatus comprising a mask assembly according to the seventh expression of the present invention.

According to a ninth expression of the present invention there is provided a grazing incidence mirror for reflecting light having an angle of incidence in the range of about 75° to 89°. The mirror comprises a MEMS according to the first or second aspect of the invention. The MEMS can comprise micromirrors or preferably a continuous reflective layer such as a metal foil. The continuous layer can prevent incident radiation from being scattered from the edges of the micromirrors and can also prevent plasma formation in the gaps and underneath the micromirrors.

According to a tenth expression of the present invention there is provided a collector for collecting light from a light source to form a radiation beam. The collector comprises a plurality of grazing incidence mirrors according to the ninth expression of the present invention.

According to an eleventh expression of the present invention there is provided an inspection and/or metrology apparatus comprising a grazing incidence mirror according to the ninth expression of the present invention, the grazing incidence mirror being configured to allow adjustment of a focus of a radiation beam on a substrate.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus with a (programmable) illuminator and a radiation source;
- Figure 1a depicts a part of a lithographic apparatus;
- Figure 1b shows a part of a lithographic apparatus configured for dark-field imaging;
- Figure 1c depicts a known inspection and/or metrology apparatus;
- Figure 1d depicts a programmable illuminator for use in the inspection and/or metrology apparatus of Figure 1c.
- Figure 2 depicts a part of a micromirror array comprising a mirror and four piezoelectric actuators;
- Figure 3 depicts a schematic cross section of a heat sink according to an embodiment.
- Figure 4 depicts a perspective view of a part of a heat sink according to an embodiment.
- Figure 5 depicts a schematic cross section of a part of a micromirror array according to an embodiment;
- Figure 6 depicts a part of a micromirror array according to another embodiment having multiple different sensing elements for sensing mirror displacement;
- Figure 7 depicts a part of a sensing element having a piezoresistor;
- Figure 8 depicts a circuit diagram of a Wheatstone bridge;
- Figure 9a depicts a configuration of resistors in a sensing element;
- Figure 9b depicts another configuration of resistors in a sensing element;
- Figure 10 depicts a cross section of a micromirror array according to an embodiment.
- Figure 11a depicts a schematic cross section of an evanescent coupling based tilt sensor according to an embodiment.
- Figure 11b is a graph showing a reflected light intensity of light in a waveguide against a distance between a first sensor element and a second sensor element in an evanescent coupling based tilt sensor according to an embodiment.
- Figure 12a depicts a schematic cross section of an evanescent coupling based tilt sensor according to an embodiment.
- Figure 12b depicts a perspective view of part of a micromirror array which is an embodiment of the invention comprising an evanescent coupling based tilt sensor.
- Figure 13a depicts a schematic cross section of part of a micromirror array which is a further embodiment of the invention.
- Figure 13b depicts a schematic cross section of part of a micromirror array which is a further embodiment of the invention.
- Figure 14 depicts a schematic cross section of a mirror forming part of a micromirror array comprising a point light source based position detector.
- Figure 15a depicts a first step in a method of forming a micromirror array;
- Figure 15b depicts a second step in a method of forming a micromirror array;
- Figure 15c depicts a third step in a method of forming a micromirror array;
- Figure 15d depicts a fourth step in a method of forming a micromirror array;
- Figure 15e depicts a fifth step in a method of forming a micromirror array;
- Figure 15f depicts a sixth step in a method of forming a micromirror array;
- Figure 15g depicts a seventh step in a method of forming a micromirror array;
- Figure 15h depicts an eighth step in a method of forming a micromirror array;
- Figure 15i depicts a ninth step in a method of forming a micromirror array;
- Figure 15j depicts a tenth step in a method of forming a micromirror array;
- Figure 16a depicts a grazing incidence mirror being a micromirror array;
- Figure 16b depicts a grazing incidence mirror according to another embodiment;
- Figure 17 depicts a grazing incidence collector according to an embodiment;
- Figure 18 depicts a part of an inspection and/or metrology apparatus comprising a grazing incidence mirror according to an embodiment;
- Figure 19a depicts a schematic top view of a pellicle and pellicle frame according to an embodiment; and
- Figure 19b shows a side view cross section of the pellicle and frame.

### DETAILED DESCRIPTION

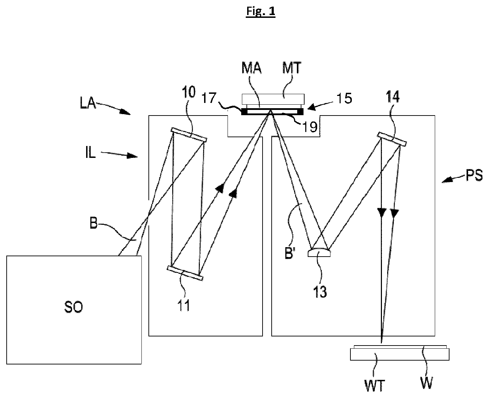

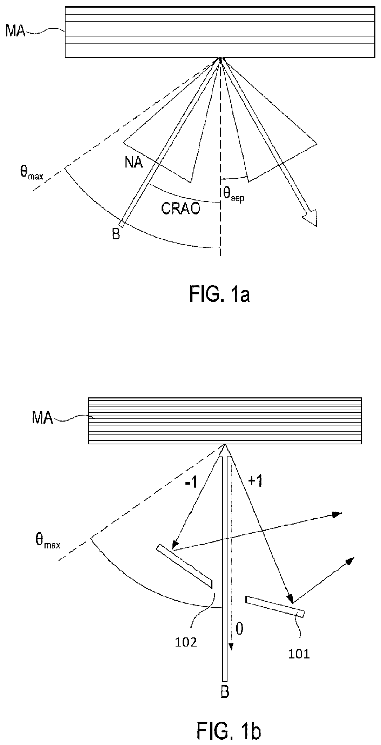

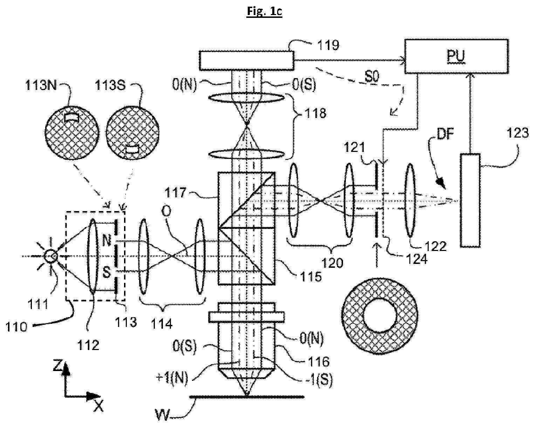

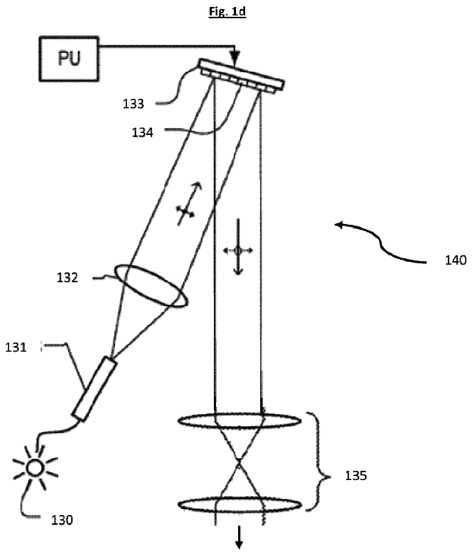

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure or mask table MT configured to support a mask assembly 15 comprising a patterning device MA, a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The illumination system IL may include other mirrors or devices in addition to, or instead of, the faceted field mirror device 10 and/or the faceted pupil mirror device 11. The radiation beam B passes from the illumination system IL and is incident upon the mask assembly 15 held by the support structure MT. The mask assembly 15 includes a patterning device MA and, optionally, a pellicle 19, which, if present, is held in place by a pellicle frame 17. The patterning device MA reflects and patterns the radiation beam B'. For example, a micromirror array as described herein may be added to the illumination system IL in addition to the facetted field mirror device 10 and faceted pupil mirror device 11 as disclosed in US 8,294,877 B2, , or may be used to replace one or both of the faceted field mirror device 10 and the faceted pupil mirror device 11 as disclosed in US 10,254,654 B2. In that case the illumination system IL, which now includes at least one micromirror array as described herein, is a programmable illuminator IL. Such a programmable illuminator IL may be used for conditioning a radiation beam used to illuminate the patterning device. For example, the programmable illuminator IL may be used to control or condition the EUV radiation beam B by providing it with a desired cross-sectional shape and/or a desired intensity distribution.

After being thus conditioned, the EUV radiation beam B illuminates the patterning device MA and interacts with it. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

In order to separate the optics in the illumination system IL (i.e. optics before the pattering device MA) and the optics of the projection system PS (i.e. the optics after the patterning device MA), a so called chief ray angle of optics (CRAO) may be used, such that the radiation beam B is incident on the patterning device MA at an angle.

Figure 1a shows a part of a lithographic apparatus, such as the lithographic apparatus LA of Figure 1, wherein the radiation beam B is incident on the patterning device MA. The patterning device is typically a mask (e.g. a binary, alternating phase-shift, or attenuated phase-shift mask) on a multilayer reflector. The multilayer reflector typically comprises alternating layers of e.g. Mo or Ru and Si. The layer thicknesses is determined by the target wavelength (e.g. 13.5 nm for EUV) so as to maximize the reflectivity at that wavelength and thereby optimize overall throughput. The reflectivity of the multilayer reflector has an angular dependence, which needs to be taken into account when used for lithography.

The radiation beam is generally a conditioned radiation beam B that has been conditioned by optics of the illumination system IL (e.g. mirrors 10 and 11 of Figure 1). The radiation beam B is incident on the patterning device MA at an angle within the numerical aperture NA centered on the CRAO. The patterning device MA has to reflect over a large angular bandwidth, to support the NA. If the angle of incidence is too large, then the patterning device MA may not accurately reflect the radiation beam B. Therefore, the angular bandwidth of the patterning device limits the maximum NA achievable at the patterning device MA.

Figure 1b shows a part of a lithographic apparatus, such as the lithographic apparatus LA of Figure 1, with an alternative configuration for separating the optics in the illumination system IL and the optics of the projection system PS using dark-field imaging. In this configuration, the radiation beam B has substantially normal incidence on the patterning device MA, which can therefore reduce the requirements on the angular bandwidth of the patterning device MA compared to CRAO. The first mirror 101 of the projection optics comprises an opening 102 for letting the radiation beam B through. The radiation beam B is diffracted by the patterning device MA, with the zeroth order diffraction sent back through the opening 102 into the illuminator (not shown). Higher order diffractions, such as the +1 and -1 diffraction orders are incident on the mirror 101 outside the opening 102 and can be projected onto the wafer (not shown) via the projection system PS.

As was described briefly above, the mask assembly 15 may include a pellicle 19 that is provided adjacent to the patterning device MA. The pellicle 19, if present, is provided in the path of the radiation beam B such that radiation beam B passes through the pellicle 19 both as it approaches the patterning device MA from the illumination system IL and as it is reflected by the patterning device MA towards the projection system PS. The pellicle 19 may comprise a thin film that is substantially transparent to EUV radiation (although it will absorb a small amount of EUV radiation). By EUV transparent pellicle or a film substantially transparent for EUV radiation herein is meant that the pellicle 19 is transmissive for at least 65% of the EUV radiation, preferably at least 80% and more preferably at least 90% of the EUV radiation. The pellicle 19 acts to protect the patterning device MA from particle contamination.

Whilst efforts may be made to maintain a clean environment inside the lithographic apparatus LA, particles may still be present inside the lithographic apparatus LA. In the absence of a pellicle 19, particles may be deposited onto the patterning device MA. Particles on the patterning device MA may disadvantageously affect the pattern that is imparted to the radiation beam B and therefore the pattern that is transferred to the substrate W. The pellicle 19 advantageously provides a barrier between the patterning device MA and the environment in the lithographic apparatus LA in order to prevent particles from being deposited on the patterning device MA.

The pellicle 19 is positioned at a distance from the patterning device MA that is sufficient that any particles that are incident upon the surface of the pellicle 19 are not in a field plane of the lithographic apparatus LA. This separation between the pellicle 19 and the patterning device MA acts to reduce the extent to which any particles on the surface of the pellicle 19 impart a pattern to the radiation beam B that is imaged onto the substrate W. It will be appreciated that where a particle is present in the beam of radiation B, but at a position that is not in a field plane of the beam of radiation B (i.e., not at the surface of the patterning device MA), then any image of the particle will not be in focus at the surface of the substrate W. In the absence of other considerations it may be desirable to position the pellicle 19 a considerable distance away from the patterning device MA. However, in practice the space which is available in the lithographic apparatus LA to accommodate the pellicle is limited due to the presence of other components. In some embodiments, the separation between the pellicle 19 and the patterning device MA may, for example, be approximately between 1 mm and 10 mm, for example between 1 mm and 5 mm, more preferably between 2 mm and 2.5 mm.

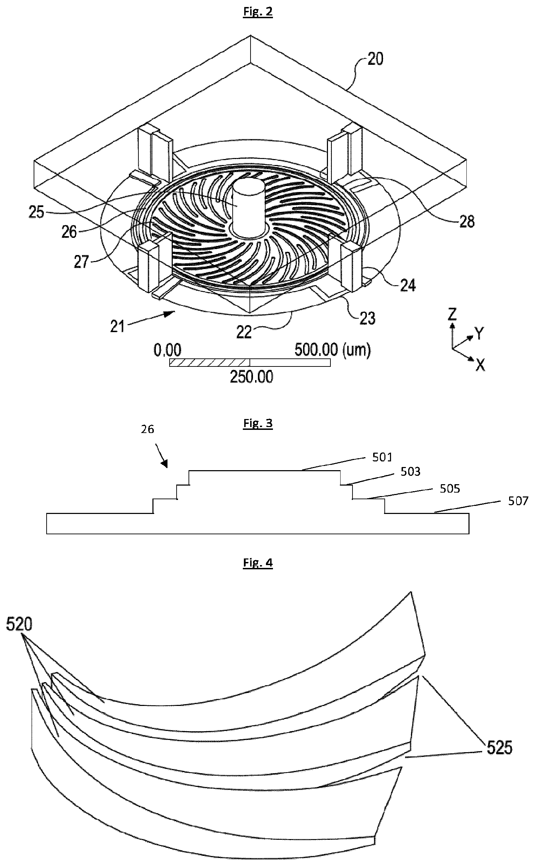

Figure 1c shows an inspection and/or metrology apparatus that is known from US 9,946,167 B2. Figure 1c corresponds to Figure 3a of US 9,946,167 B2. The inspection and/or metrology apparatus is a dark field metrology apparatus for measuring e.g. overlay and/or alignment.

In lithographic processes, it is desirable to frequently make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device and alignment, i.e. the position of alignment marks on the substrate. Various forms of scatterometers have been developed for use in the lithographic field. These devices direct a beam of radiation onto a target structure, e.g. a grating or mark(er), and measure one or more properties of the scattered radiation - e.g., intensity at a single angle of reflection as a function of wavelength; intensity at one or more wavelengths as a function of reflected angle; or polarization as a function of reflected angle - to obtain a "spectrum" from which a property of interest of the target can be determined. Determination of the property of interest may be performed by various techniques: e.g., reconstruction of the target structure by iterative approaches such as rigorous coupled wave analysis or finite element methods; library searches; and principal component analysis.

The dark field metrology apparatus shown in Figure 1c may be a stand-alone device/system or may be incorporated in the lithographic apparatus LA as an alignment system and/or as an overlay measurement system (not shown). An optical axis, which has several branches throughout the apparatus, is represented by a dotted line O. In this apparatus, light emitted by radiation source 111 (e.g., a xenon lamp) is directed onto a substrate W via a beam splitter 115 by an optical system comprising lenses 112, 114 and objective lens 116. These lenses are arranged in a double sequence of a 4F arrangement. Therefore, the angular distribution at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 113 of suitable form between lenses 112 and 114, in a plane which is a back-projected image of the objective lens pupil plane. In the example illustrated, aperture plate 113 has different forms, labeled 113N and 113S, allowing different illumination modes to be selected. The illumination system in the present example forms an off-axis illumination mode. In the first illumination mode, aperture plate 113N provides off-axis from a direction designated, for the sake of description only, as 'north'. In a second illumination mode, aperture plate 113S is used to provide similar illumination, but from an opposite direction, labeled 'south'. Other modes of illumination are possible by using different apertures. The rest of the pupil plane is desirably dark, as any unnecessary light outside the desired illumination mode will interfere with the desired measurement signals.

A target structure (not shown), e.g. a grating or mark(er), on substrate W is placed normal to the optical axis O of objective lens 116. A ray of illumination impinging on the target structure from an angle off the axis O gives rise to a zeroth diffraction order ray and two first diffraction order rays. Since the aperture in plate 113 has a finite width (necessary to admit a useful quantity of light) the incident rays will in fact occupy a range of angles, and the diffracted rays 0 and +1/-1 will be spread out somewhat. According to the point spread function of a small target, each order +1 and -1 will be further spread over a range of angles, not a single ideal ray. Note that the grating pitches and illumination angles can be designed or adjusted so that the first order rays entering the objective lens are closely aligned with the central optical axis.

At least the 0 and +1 orders diffracted by the target on substrate W are collected by objective lens 116 and directed back through beam splitter 115. Both the first and second illumination modes are illustrated, by designating diametrically opposite apertures labeled as north (N) and south (S). When the incident ray is from the north side of the optical axis, that is when the first illumination mode is applied using aperture plate 113N, the +1 diffracted rays, which are labeled +1(N), enter the objective lens 116. In contrast, when the second illumination mode is applied using aperture plate 113S the -1 diffracted rays (labeled -1(S) are the ones which enter the lens 116.

A second beam splitter 117 divides the diffracted beams into two measurement branches. In a first measurement branch, optical system 118 forms a diffraction spectrum (pupil plane image) of the target on first sensor 119 (e.g. a CCD or CMOS sensor) using the zeroth and first order diffractive beams. Each diffraction order hits a different point on the sensor, so that image processing can compare and contrast orders. The pupil plane image captured by sensor 119 can be used for focusing the inspection and/or metrology apparatus and/or normalizing intensity measurements of the first order beam. The pupil plane image can also be used for many measurement purposes such as reconstruction.

In the second measurement branch, an optical system including lenses 120, 122 forms an image of the target on the substrate W on sensor 123 (e.g. a CCD or CMOS sensor). In the second measurement branch, an aperture plate referred to as field stop 121 is provided in a plane that is conjugate to the pupil-plane. This plane will be referred to as an 'intermediate pupil plane' when describing the invention. Field stop 121 functions to block the zeroth order diffracted beam so that the image of the target formed on sensor 123 is formed only from the -1 or +1 first order beam. The images captured by sensors 119 and 123 are output to image processor and controller PU, the function of which will depend on the particular type of measurements being performed. Note that the term 'image' is used here in a broad sense. An image of the grating lines as such will not be formed, if only one of the -1 and +1 orders is present.

The illumination system of the inspection and/or metrology apparatus comprises an illuminator 110. As shown in Figure 1c, this illuminator 110 comprises lens 112 and aperture plate 113. More details of the inspection and/or metrology apparatus can be found in US 9,946,167 B2.

Figure 1d shows a programmable illuminator 140 for use in the inspection and/or metrology apparatus of Figure 1c. This programmable illuminator 140 can be used in the inspection and/or metrology apparatus of Figure 1c instead of the illuminator 110. The programmable illuminator 140 comprises a micromirror array 133 according to the present invention as well as a low NA relay 4F system 135 comprising a pair of lenses. Radiation or light from a radiation source 130 (not part of the programmable illuminator 140), e.g. a broad band radiation source or white light source, may be directed via an optional fiber 131 and an optional collimating lens system 132 to the micromirror array 133. A processing unit PU can control the micromirror array 133 in such a way that the micromirrors 134, or more precise the mirrors in the micromirrors 134, in the micromirror array 133 are tilted individually. By tuning the tilt angle of each individual mirror independently, the spatial distribution of the light that is output by the low NA relay system 135 can be controlled and various illumination modes can be made as desired without having to use aperture plates. If the programmable illuminator 140 is used in the inspection and/or metrology apparatus of Figure 1c it interfaces with lenses 114, meaning that the light that is output by the low NA relay system 135 is received by the lenses 114 of Figure 1c.

In order to control the spectral distribution of the light that is output by the low NA relay system 135 at least part of the mirrors may comprise a grating on top of the mirror surfaces (not shown). The grating may be the same for all mirrors or, alternatively, different gratings, e.g. gratings having different pitches, may be used. By appropriate control of the micromirror array 133 the light that is output by the low NA relay system 135 comprises a single wavelength or a single (narrow) range of wavelengths. It is however also possible to control the micromirror array 133 in such a way that the light that is output by the low NA relay system 135 comprises a number of different wavelengths or a number of different (narrow) ranges of wavelengths. The gratings may be lithographically patterned on the mirror surfaces. Each mirror with grating diffracts light of different wavelengths in different directions according to the associated grating equation. A portion of the diffracted light is captured by the low NA relay system 135 and an image is formed. By tuning the angle of each mirror independently, the light distribution at the output can be controlled both spatially and spectrally as (a) certain diffraction order(s) will be captured by the low NA relay system 135 and (an)other diffraction order(s) will not be captured. Such a spatial and spectral light distribution can be used advantageously for example for illuminating and measuring an overlay target structure on a substrate or for measuring the position of an alignment mark on a substrate. In this text, the terms target structure, target, mark, marker and grating are, where the context allows, all synonyms of each other.

The spectral bandwidth of the diffracting beam which can be captured by the low NA relay system 135 is dλ=P.NA where P is the pitch of the grating and NA is the numerical aperture of the low NA relay system 135. With P=500nm and NA=0.02 the spectral bandwidth is 10nm, meaning that a diffraction order of the grating comprises a range or band of wavelengths of 10nm.

The spatial resolution of the low NA relay system 135 is ~ λ/NA. With λ=850nm and NA=0.02 the spatial resolution is 42.5 micrometer. If the size of the mirrors is greater than 42.5 micrometer, each mirror can be resolved. A reasonable size of a mirror is 100x100 micrometer.

By rotating/tilting the mirrors around their individual axis, a different central wavelength band can be directed into the low NA relay system 135. The rotating range of each mirror required for operation over the visible wavelength range should be Δλ/2P, where Δλ=400nm for an operating wavelength range of 450nm-850nm. This means that each mirror must be able to rotate by 0.4 radians.

The MEMS system shown in Figure 2 is a micromirror with a mirror 20 and four piezoelectric actuators 21 for displacing the mirror 20. In other embodiments (not shown) the micromirror may have a different number of piezoelectric actuators 21 for displacing the mirror 20. In all these embodiments the micromirror has at least one piezoelectric actuator 21 for displacing the mirror 20. A number of micromirrors as shown in Figure 2 can be arranged in an array to form a micromirror array.

Figure 2 shows a MEMS system with a mirror 20 which may be a part of a micromirror array according to an embodiment. The MEMS system has a four-fold rotational symmetry about an axis. In particular, four piezoelectric actuators 21 are arranged symmetrically under the mirror 20 to enable tip and tilt displacement of the mirror 20. The mirror 20 is typically rectangular (which in this document is used to include square) with each side being in the range 0.5mm to 2.5mm. For example, it may be square with a 1 mm² surface area. In other embodiments the mirror may be another shape, such as hexagonal. Each piezoelectric actuator 21 has a curved strip of flexible material 22, fixed to the underlying substrate (no shown) at one end and connected via a hinge 23 to a pillar 24. The strip of flexible material 22 has an elongation direction which at rest lies substantially parallel to the plane of the front surface of the mirror 20. The strip of flexible material 22 has a layer of piezoelectric material (e.g. PZT) on it, to which a voltage can be applied in order to activate the piezoelectric actuator 21. When activating the piezoelectric actuator 21, the strip 22 bends, acting as a cantilever, to displace the mirror 20 via the pillar 24. The magnitude of the displacement is a function of the applied voltage (as well as being a function of other parameters, such as the geometry of the piezoelectric actuator). The hinge 23 is formed by narrowing the strip 22 at one end, so that the cross sectional area of the hinge 23 is smaller than that of the strip 22 along the elongation direction of the strip 22. The hinge 23 is therefore less stiff than the strip 22, which allows it to act as a hinge. The hinge is typically required to flex in a plane transverse to an axis direction, which itself is transverse to the elongation direction of the strip 22.

The mirror 20 is also connected to a heat diffuser, comprising a thermally conductive post 25 connected to the center of the back of the mirror 20, and a heat sink 26 connected to the other end of the post 25. In a rest condition, the length direction of the post 25 is the axis of four-fold rotational symmetry of the MEMS system. The thermally conductive post 25 is arranged to transfer heat from the mirror 20 to the heat sink 26, which diffuses the heat over a relatively large surface area. The heat sink 26 comprises a flexible membrane being a circular, patterned silicon layer. It may alternatively have multiple layers; if so, one or more (e.g. all) of the layers may be silicon, and one or more layers may be of material of other than silicon. The flexible membrane has curved grooves 27 formed in it, which increase the flexibility of the flexible membrane. In use, when the mirror 20 is displaced, the thermally conductive post 25 pivots and elastically deforms the flexible membrane.

Each piezoelectric actuator 21 is associated with a sensing element 28, being a piezoresistor fixed to the pillar 24 at one end and to the underlying substrate at the other. As the pillar 24 is displaced, the piezoresistor is stressed/deformed, which changes the electric properties of the piezoresistor, from which the displacement can be determined. For example, the piezoresistor may be connected in a Wheatstone bridge, configured so that the output voltage of the bridge is a function of the displacement of the mirror 20. The output from the piezoresistor is temperature sensitive, and temperature compensation may be used to increase the accuracy of displacement measurements.

The microelectromechanical system (MEMS) used to displace the mirrors 20 can be advantageously incorporated in other parts of the lithographic apparatus and/or the inspection and/or metrology apparatus. Looking at Figure 2, the mirror 20 of each MEMS element can be replaced by a displacement structure being any form of non-reflective object that fits over the MEMS element, and which translates the displacement from the piezoelectric actuators 21. Such a displacement structure can have the same shape and dimensions as the mirror (e.g. square as in Figure 2), but does not require a reflective top surface. Instead of directly reflecting incident light, the displacement structure can be used to deform an overlying structure, such as a continuous reflective layer of a mirror. In this way, the MEMS can be incorporated in the patterning device to deform the multilayer reflector and thereby redirect incident light. Alternatively, instead of replacing the mirror 20 with a displacement structure, the pillars 24 connected to the piezoelectric actuators 21 may be directly bonded to the overlying structure. That is, the pillars 24 may be directly bonded to the underside of the overlying structure (e.g. the underside of a multilayer reflector), in order to deform that structure with the piezoelectric actuators 21.

Figure 3 shows a schematic diagram of a cross section of the heat sink 26 in an embodiment according to a first aspect of the present invention. The heat sink comprises a flexible membrane which comprises Z portions from z = 1 to z = Z. In this instance, Z is equal to four. However, Z may be any integer greater than one, and preferably greater than two. The heat sink 26 comprises a center portion 501 (z=1) that has a thickness greater than a thickness of a peripheral portion 507 (z=4). The heat sink 26 further comprises a first intermediate portion 503 (z=2), and a second intermediate portion 505 (z=3). The first intermediate portion 503 encircles the center portion 501, and has a thickness less than the thickness of the center portion 501. The second intermediate portion 505 encircles the first intermediate portion 503, and has a thickness less than the thickness of the first intermediate portion 503. The peripheral portion 507 encircles the second intermediate portion 505, and has a thickness less than the thickness of the second intermediate portion 505. The thickness of the flexible membrane decreases from the center of the flexible membrane to the periphery of the flexible membrane. For each value of z, the thickness of the flexible membrane is substantially proportional to 1/R(z) where R(z) is an average distance of a given portion z from the center of the flexible membrane.

Figure 4 shows a schematic diagram of a part of the heat sink 26 according to the first aspect of the present invention. This part of the heat sink 26 is part of the flexible membrane which subtends an angle of about 30 degrees about the central portion of the flexible membrane. In this instance, Z is very large, and so the surface of the heat sink 26 appears smooth. The thickness of the heat sink 26 varies from a higher thickness at the center of the heat sink 26 (to the left in Figure 4) to a lower thickness at the periphery of the heat sink 26 (to the right in Figure 4). As explained above with reference to Figure 2, the heat sink 26 comprises grooves 525, and the grooves 525 partition this part of the flexible membrane into elongate slices 520.

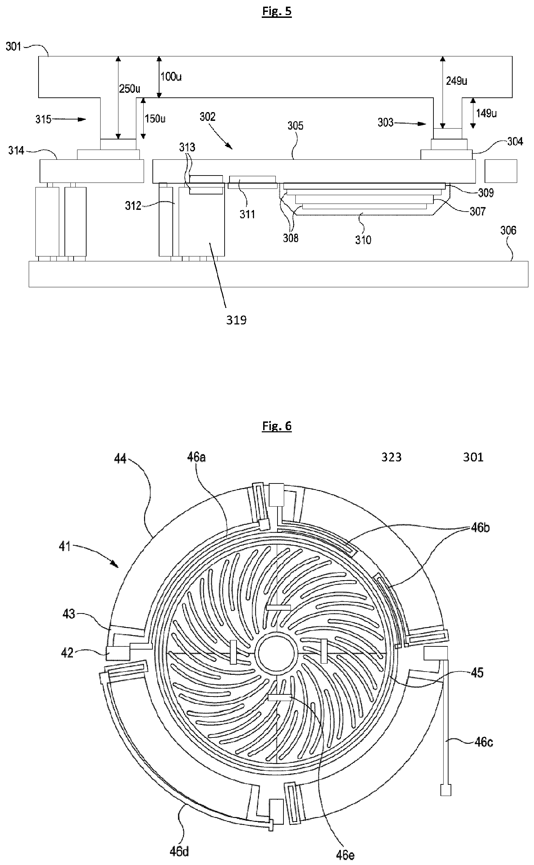

Figure 5 shows a schematic diagram of a cross section of a part of a micromirror array 300 according to an embodiment. A mirror 301 is connected to a piezoelectric actuator 302 via a pillar 303. The pillar 303 comprises layers of silicon, germanium, aluminum and oxide having a combined thickness of 151 µm. The oxide layer 304 has a thickness of 1 µm and provides both thermal and electrical insulation to protect the piezoelectric actuator 302.

The piezoelectric actuator 302 comprises a strip of flexible material 305, being a 5 µm thick strip of silicon, connected to a substrate 306 at the opposite end from the pillar 303. The piezoelectric actuator 302 also comprises a layer of piezoelectric material 307 being a layer of PZT having a thickness in the range of 500 nm to 2 µm. The layer of piezoelectric material 307 has top and bottom electrodes 308 made of platinum (Pt) and LaNiO3 (LNO) for applying a voltage to the layer of piezoelectric material 307. The layer of piezoelectric material is bonded to the strip of flexible material 305 by a layer of nitride (SiN) 309 having a thickness of 100 nm. The stack of SiN/Pt/LNO/PZT/Pt/LNO is covered by a layer of silicon oxide and aluminum oxide 310. Applying a voltage to the electrodes 308 causes the layer of piezoelectric material 307 to contract or expand, but because the layer is constrained at the interface to the strip of flexible material 305, the combined system of the layer of piezoelectric material 307 and the strip of flexible material 305 bends. It is this bending motion of the piezoelectric actuator 302 which displaces the pillar 303 and thereby also the mirror 301.

A sensing element 311 comprising a piezoresistor is embedded in the strip of flexible material 305 and covered by oxide. The sensing element 311 is arranged to sense the deflection of the piezoelectric actuator 302.

The piezoelectric actuator 302 is electrically connected to the substrate 306 by a through silicon via (TSV) 312. Application specific integrated circuits (ASICs) 313 can be used to apply the voltage to the piezoelectric actuator 302 and also to derive the output voltage from the sensing element 310.

The mirror 301 is connected to a heat sink 314 by a thermally conductive post 315. The heat sink 314 and the thermally conductive post 315 together form a heat diffuser for dissipating heat from the mirror 301. The post 315 comprises layers of silicon, germanium and aluminum. The heat sink 314 comprises a flexible member, specifically in this example a flexible membrane of silicon, which allows the post 315 to move as the mirror 301 is displaced. The heat sink 314 is electrically connected to the substrate 306, and may be grounded to prevent charge build up on the mirror 301. The heat sink 314 and the strip of flexible material 305 are in the same plane and may be formed from the same silicon wafer. The spacing between the lower surface of the mirror 301 and the upper surface of the heat sink 314 and/or the strip of flexible material 305 may be in the range 50µm-120µm, such as about 80µm. Typically, known micromirror arrays have a smaller spacing than this, such as only a few microns. The greater spacing is achieved in this embodiment because the actuation force is generated on the strip of flexible material 305, rather than, for example, by an actuator mounted on the mirror itself, which would typically limit the range of movement of the mirror to the range of relative movement of components of the electrostatic actuator.

The spacing between the lower surface of the heat sink 314 and/or the strip of flexible material 305, and the upper surface of the substrate may be in the range 50µm-120µm, such as about 80µm.

Each mirror may be provided with one or more control units which are operative to recognize, in a received control signal, an address corresponding to the mirror, and, upon recognizing the address, to generate control voltages for one or more piezoelectric actuators of the mirror based on control information additionally contained in the control signal. The control units may be implemented as the ASICs 313 which receive the control signals using the vias 312 and control the corresponding piezoelectric actuator 302 based on it; in this case, the address in the control signal may specify not only the mirror but also the ASIC 313 for a given piezoelectric actuator 302. Using the control units, an external control system is able to individually control all the mirrors of the mirror array, by transmitting identical control signals to the control units of all of the mirrors, such that each control unit recognizes control signals addressed to it, and controls the corresponding piezoelectric actuator(s) accordingly. Positioning the ASICs 313 within the structure, e.g. supported above the substrate 306 and proximate to (e.g. substantially in plane with) the strip of flexible material 305, is achievable because the embodiment may be formed in multiple layers by a MEMS process, as described below.

Figure 6 shows a schematic diagram of a top view of a MEMS system 40 for controlling a mirror (not shown) in a micromirror array according to an embodiment. The system 40 comprises four piezoelectric actuators 41 connected to the mirror by respective pillars 42. Each piezoelectric actuator 41 comprises a strip of flexible material 43 and a hinge 44, wherein the pillar 42 is connected to the hinge 44 at one end of the strip 43 and wherein the other end of the strip 43 is connected to (that is, in a substantially fixed positional relationship to) the substrate (not shown). The system 40 also comprises a heat diffuser 45 for diffusing heat from the mirror when in use. The heat diffuser 45 comprises a circular silicon layer fixed to the substrate along an outer edge of the silicon layer and a thermally conductive post connected to the center of the silicon layer.

The system 40 comprises any one or more of five different types of sensing elements 46a to 46e illustrated in Figure 6 for sensing a displacement of the mirror. Each sensing element 46a to 46e comprises a piezoresistor arranged so that displacement of the mirror induces stress in the piezoresistor. Preferably, each of the actuators is provided with only one of these five types of sensing element 46a to 46e, and the same type of sensing element is used in each of the four actuators.

A first type of sensing element 46a comprises a curved beam located in the annular space between the heat diffuser 45 and the piezoelectric actuator 41 and fixed to the substrate at one end and to the pillar 42 at the opposite end. One or more piezoresistors may be formed in the beam.

A second type of sensing element 46b comprises two folded beams comprising respective piezoresistors, each located in the annular space between the heat diffuser 45 and the piezoelectric actuator 41. One of the folded beams is connected to the substrate and to the pillar 42, whereas the other folded beam is connected to two different points of the substrate to provide a reference value.

A third type of sensing element 46c comprises a straight beam comprising a piezoresistor connected to the pillar 42 at one end and to the substrate at the other end.

A fourth type of sensing element 46d comprises a curved beam comprising a piezoresistor, the beam being located outside the piezoelectric actuator 41. The beam is connected to the substrate at one end and to the pillar 42 at the opposite end.

A fifth type of sensing element 46e comprises four piezoresistors fixed to the heat diffuser 45. The fifth sensing element 46e is for sensing deformation of the heat diffuser caused by displacement of the mirror.

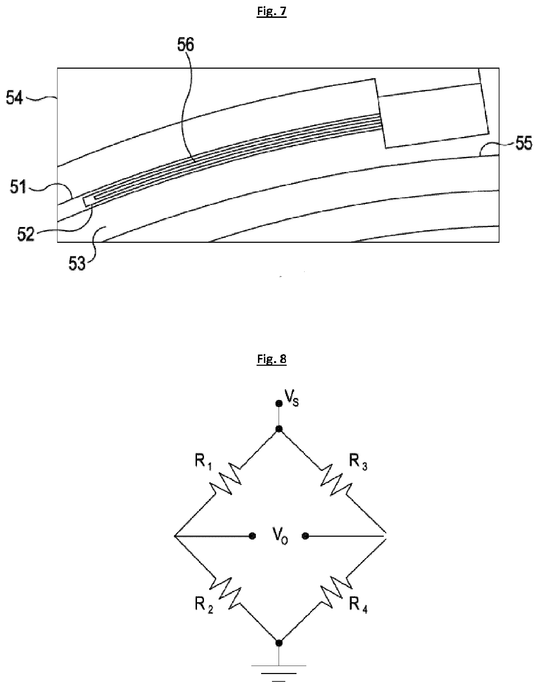

Figure 7 shows a schematic diagram of a top view of a part of a sensing element 50, which may be the first sensing element 46a in Figure 6 but the other sensing elements have a similar construction. The sensing element 50 comprises a curved beam 51 and a folded piezoresistor 52 in the annular space 53 between the piezoelectric actuator 54 and the heat diffuser 55. A temperature sensor 56 may be provided to measure the temperature of the piezoresistor 52. The temperature sensor may for example be implemented as a bipolar transistor or a diode, since for such devices the current is a function of temperature.

Figure 8 shows a circuit diagram of a Wheatstone bridge having a supply voltage Vₛ, resistors R1, R2, R3 and R4, and output voltage Vₒ. The circuit may be a part of the sensing element for sensing displacement of the mirror in a micromirror array. One or more of the resistors R1 to R4 may be piezoresistors of the sensing element.

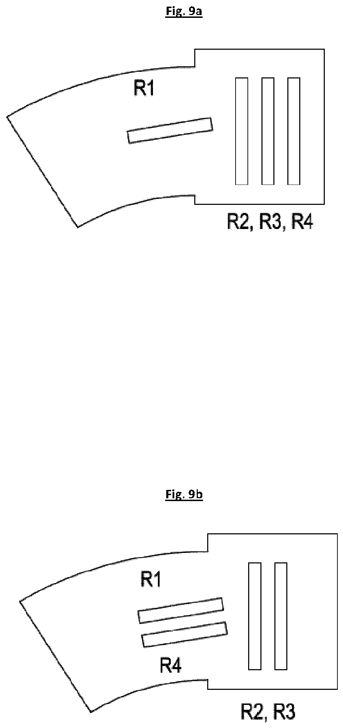

Figure 9a shows a schematic diagram of a particular configuration of resistors R1 to R4 of the Wheatstone bridge in a sensing element 70 comprising a curved beam 71. R1 is a piezoresistor extending along the elongation direction of the beam 71 towards the moving end of the beam. R2 to R4 are located at the end of the sensing element 70 that is fixed to the substrate. As the beam 71 is deflected/stressed due to displacement of the mirror, the resistance of R1 changes while the resistances of R2 to R4 remain substantially constant.

Figure 9b shows a schematic diagram of an alternative configuration of the resistors R1 to R4 of the Wheatstone bridge in a sensing element 70 comprising a curved beam 71. In this configuration, two piezoresistors (R1 and R4) extend along the elongation direction of the beam 71, while R2 and R3 are located at the end of the sensing element that is fixed to the substrate. As the beam 71 is deflected/stresses due to displacement of the mirror, the resistance of R1 and R4 changes while the resistances of R2 and R3 remain substantially constant.

As mentioned above, one or more of the piezoresistors R1 to R4 may be provided with a temperature sensor. In this case, the temperature value output by the temperature sensor(s) may be employed (using circuitry which is not shown) to modify the operation of the sensing element to correct for temperature variations in the piezoresistors, i.e. to correct for temperature variations in the relationship between resistance and deflection/stress in the resistors R1 to R4.

Embodiments of the micromirror array can provide tip and tilt displacement range of +/-120 mrad and a mirror accuracy of 100 µrad. Embodiments of the micromirror array can be operated at high light intensities as required for EUV, and may work at 40 to 60 kW/m² of absorbed thermal power density (which implies an incident light power density on the surface of the mirror which is even larger). This is orders of magnitude higher than the absorbed thermal power density of micromirror arrays used in some other applications. This is possible because the piezoelectric actuators 41 are operative to provide, even at a relatively low actuator voltage (e.g. under about 100V), such a strong force that they are able to deform the flexible member 314 even though the flexible member is thick enough to provide high heat conductivity to the substrate. Due to the high thermal conductivity, the micromirror array may in use have a temperature of under about 100 degrees Celsius.

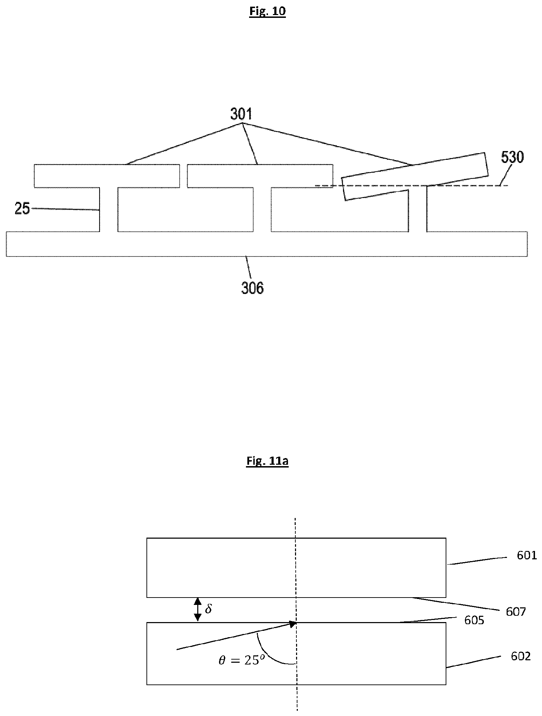

Fig 10 shows a schematic view of a micromirror array according to the second aspect of the present invention. Figure 10 shows three mirrors 301 connected by thermally conducting posts 25 to the substrate 306. The two mirrors to the left lie in a rest configuration in which their reflective surfaces (the upper surfaces in Figure 10) are parallel to a plane 530. This plane is parallel to an overall plane of the substrate 306. The mirror 301 furthest to the right is offset from the rest position at an angle relative to the plane 530. The tilt of the mirror 301 that is furthest to the right in the diagram is a result of an actuating force from the actuator. The optical tilt sensor is configured to measure the angle of the mirror 301 relative to the plane 530.

The optical tilt sensor may be an evanescent coupling based tilt sensor. An evanescent coupling based tilt sensor is based on the principle of frustrated total internal reflection. When light is incident on the interface between a high and low index medium from the high index side and when the angle between the light and the interface is small, total internal reflection occurs; light gets completely reflected back from the interface. We can refer to the interface as a first surface. At the near field of the first surface, there exists an evanescent wave, an exponentially decaying electric field component. If a second surface is brought close to the first surface, light can couple to the second surface. The amount of light that couples to the second surface is a function of the distance between the first surface and the second surface.

Figure 11a shows a schematic diagram of an evanescent coupling based tilt sensor. The evanescent coupling based tilt sensor comprises a waveguide 602. The waveguide 602 may comprise a body of silicon, for example. Light is emitted from a light source (not shown in Figure 11a) into the waveguide 602 from the left of Figure 11a, and is reflected from a first surface 605 of the waveguide 602. The angle between the emitted light and the first surface θ is sufficiently high that total internal reflection can occur.

Figure 11a also shows a second body 601, comprising a second surface 607. The second body 601 may also comprise silicon. There is a gap between the first surface 605 and the second surface 607. The gap may be a vacuum or may be filled with a gas or plasma. The distance between the first surface 605 and the second surface 607 is δ. When δ is large, the second surface does not have an effect on the total internal reflection within the waveguide 602. However, when δ is small, evanescent coupling can occur between the first surface 605 and the second surface 607, meaning that not all of the light is reflected by the first surface 605 of the waveguide 602. The amount of light reflected at the first surface 605 is dependent on δ. When δ is small, less light is reflected than when δ is large. A light detector (not shown in Figure 11a) can be used to detect the amount of light that exits from the end of the waveguide 602 at the right of Figure 11a. The amount of light detected can be used to determine the distance δ between the first surface 605 and the second surface 607.

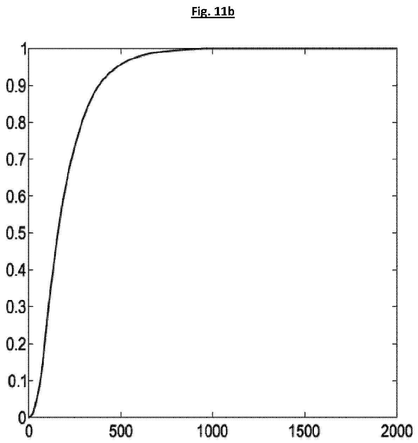

Figure 11b is a graph showing the proportion of light that is detected by the light detector plotted against the distance δ between the first surface 605 and the second surface 607. The x axis represents the distance δ in nm. The y axis represents the amount of light received at the light detector divided by the amount of light emitted into the waveguide (and so has no units).

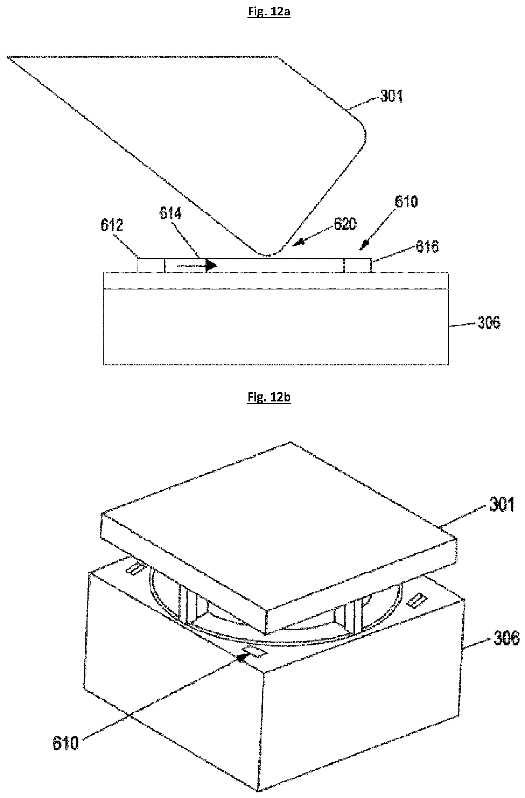

Figure 12a shows an example of an evanescent coupling based tilt sensor when used as part of a micromirror array of an embodiment. The evanescent coupling based tilt sensor comprises a first sensor element 610 and a second sensor element 620. The first sensor element 610 comprises a light source 612, a waveguide 614, and a light detector 616. The first sensor element is positioned on a surface of the substrate 306 facing towards the mirror 301. The second sensor 620 element is positioned on the mirror 301. The second sensor element 620 may be a surface portion of the mirror 301 at a surface of the mirror 301 that faces towards the substrate 306. Here the term "faces towards" is used to mean that a normal to the surface of the mirror surface 301, in the direction outwards from the mirror, intercepts the substrate. The second sensor element 620 may in fact be on a surface of the mirror 301 which, when the mirror 301 is in the rest position shown in Figure 10, is parallel to the overall plane of the substrate 306. The second sensor element 620 may be at a corner of said surface of the mirror 301, or may be positioned proximate to a corner of said surface of the mirror 301.

Light is emitted from the light source 612 into the waveguide 614 at an angle allowing at least one internal reflection to occur. The angle is preferably an angle at which total internal reflection occurs within the waveguide 614 when no external objects are placed close to the waveguide 614. The light detector 616 is positioned at an end of the waveguide 614.

As the mirror 301 is tilted by the actuator towards the first sensor element 610, the second sensor element 620 moves closer to the first sensor element 610. When the distance δ between the first sensor element 610 and the second sensor element 620 is sufficiently small, evanescent coupling occurs between an evanescent field formed at a surface of the waveguide 614 and the second sensor element 620. This results in a smaller amount of light being reflected at the surface of the waveguide 614, and thus a smaller amount of light is detected by the light detector 616. The amount of light detected at the light detector 616 varies inversely with the distance δ between the first sensor element 610 and the second sensor element 620.

Figure 12b shows a schematic diagram of the micromirror array according to the second aspect of the present invention. The first sensor element 610 is shown positioned on a surface of the substrate 306 facing towards the mirror 301. In such an instance the second sensor element 620 is a surface portion of the mirror 301 located on an opposed surface (not visible in Figure 12b, but generally rectangular) of the mirror. The second sensor element is directly above the first sensor element in an "upward" direction extending perpendicularly from the surface of the substrate 306. Thus, the second sensor element is proximate a corner of the rectangular surface of the mirror which faces the substrate 306.

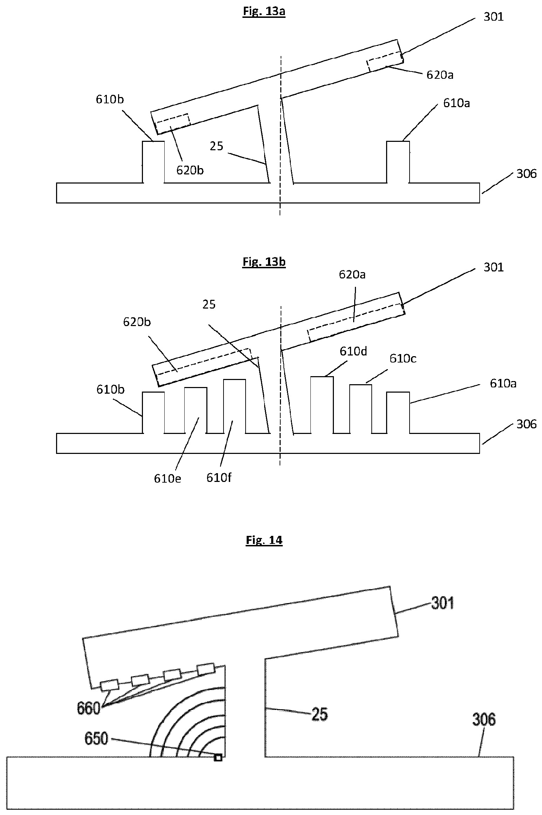

Figure 13a shows a schematic diagram of another micromirror array according to the second aspect of the present invention. The micromirror array includes a first sensor element 610a of a first evanescent coupling based tilt sensor, and a first sensor element 610b of a second evanescent coupling based tilt sensor. The two evanescent coupling based tilt sensors are placed at opposite ends of the mirror 301. The first evanescent coupling based tilt sensor can detect the mirror when it tilts downwards on the right hand side, and a surface portion (second sensor element) 620a of the mirror approaches the first sensor element 610a. The second evanescent coupling based tilt sensor can detect the mirror when it tilts downwards on the left hand side, and a surface portion (second sensor element) 620b of the mirror approaches the first sensor element 610b. In practice, evanescent coupling based tilt sensors would be positioned at all four corners of a surface of the mirror 301 facing towards the substrate 306 (if the mirror is taken to be rectangular; they might be at all three corners if the mirror is triangular, or all six corners if the mirror is hexagonal). This allows the tilt of the mirror 301 to be detected in all directions.

Figure 13b shows a schematic diagram of another micromirror array according to the second aspect of the present invention. According to this expression, there are third sensor elements 610c, 610d, positioned between the thermally conducting post 25 and the first sensor element 610a, and third sensor elements 610e, 610f positioned between the thermally conducting post 25 and the first sensor element 610b. Each of the third sensor elements 610c, 610d, 610e, 610f comprises a light source 612, a waveguide 614, and a light detector 616, arranged in the same was as in the first sensor element 610. Each of the sensor elements 610a, 610c, 630d interacts with a surface portion (second sensor element) 620a of the mirror 301 which, as seen in Figure 13, is the underside of the mirror 301 to the right of the post 25. Each of the sensor elements 610b, 610e, 630f interacts with a surface portion (second sensor element) 620b of the mirror 301 which, as seen in Figure 13, is the underside of the mirror 301 to the left of the post 25.

Considering the third sensor elements 610c, 610d between the thermally conducting post 25 and the first sensor element 610a, when the mirror is in the (horizontal) rest position, the third sensor element 610d closest to the thermally conducting post extends closer the surface of the mirror 301 facing the substrate than third sensor element 610c, and third sensor element 610c extends closer to the surface of the mirror 301 facing the substrate than the first sensor element 610a. This configuration allows for improved detection of the surface of the mirror 301 facing towards the substrate 306. When the mirror tilts slightly downwards on the right hand side, the surface of the mirror 301 is first detected by third sensor element 610d. This means that small changes from the horizontal position of the mirror 301 can be detected. As the mirror 301 tilts further, it is detected by third sensor element 610c, and as it tilts further still, it is detected by the first sensor element 610a. A small change in the angle from the horizontal of the mirror 301 will result in a greater change in the distance between the mirror 301 and the first sensor element 610a than in the distance between the mirror 301 and the third sensor elements 610c and 610d. This means that the first sensor element 610a furthest from the thermally conducting post can make more sensitive measurements regarding the tilt of the mirror 301 when the tilt is high. However, first sensor element 610a has little interaction with the second sensor element 620a when the mirror 301 is in the rest position. Only the third sensor element 610d is close enough to the second sensor element 620a to detect a small tilt of the mirror 301 to the right. The third sensor element 610c is useful for detecting the tilt angle of the mirror when the tilt is in an angular range between that detected by the first sensor element 610a and that detected by the third sensor element 610d.

The micromirror array may comprise any number of third sensor elements. There may be one or more additional third sensor elements for each evanescent coupling based tilt sensor.

The micromirror array may comprise a calculation unit to calculate the tilt of the mirror 301 based on the amount of light received at the light detectors 616. Alternatively, the information from the light detectors 616 may be transmitted to an external device to calculate the tilt of the mirror. Alternatively, the tilt of the mirror 301 may not be directly calculated, but instead the information from the light detectors 616 may be input to a control unit (e.g. a neural network) which outputs control signals which are transmitted to the actuators to cause adjustments to the positions of the mirror 301.

According to an alternative aspect of the present invention, the micromirror array may comprise yet another form of light sensor to detect the tilt of the mirror 301. Figure 14 shows a light source sensor comprising a light source 650, positioned on the substrate 306, and an array of light detectors 660 placed on a surface of the mirror 301 facing towards the substrate 306. In this example, the light source 650 is assumed to be a point source emitting spherical waves. The light intensity detected by a light detector 660 at a distance R from the source will be proportional to 1/R². As the mirror 301 tilts, the intensity detected by each detector 660 will record an intensity changing as a function of the tilt. The outputs of the detectors 660 may be transmitted to a calculation unit to determine the tilt of the mirror.

According to this aspect of the invention, the micromirror array may comprise a calculation unit to calculate the tilt of the mirror 301 based on the amount of light received at the light detectors 660. Alternatively, the information from the light detectors 660 may be transmitted to an external device to calculate the tilt of the mirror. Alternatively, the tilt of the mirror 301 may not be directly calculated, but the information from the light detectors 660 may be processed by a control unit (e.g. neural network) to generate control signals to cause adjustments to the positions of the mirrors 301.

In a variation, the light detectors 660 and the light source 650 could be arranged differently to how they are shown in Figure 14. For example, the light detectors 660 could be positioned on the substrate 306 next to the light source 650 in a one dimensional or two dimensional configuration to detect light reflected back from the surface of the mirror 301 facing towards the substrate 306.

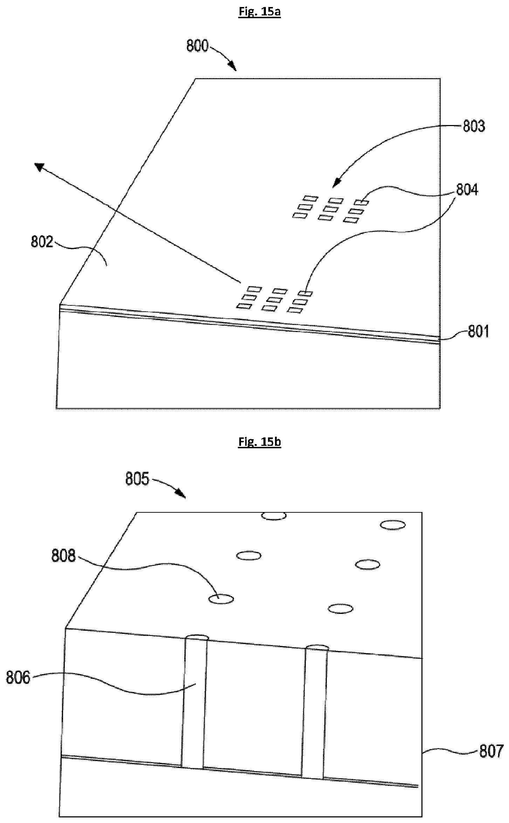

Methods of forming a micromirror array are also described herein. Figures 15a to 15j illustrate some of the steps of an embodiment of such a method.

As illustrated in Figure 15a, the method comprises providing a first silicon wafer 800 for forming the actuators and sensing elements. The first wafer 800 may be referred to as the "actuator wafer". The actuator wafer may be a silicon on insulator (SOI) wafer with a 4 µm silicon film 801. Low voltage active devices such as the sensing elements can be formed in the wafer 800 using a Complementary Metal Oxide Semiconductor (CMOS) Front End of Line (FEOL) process. A CMOS Back End of Line (BEOL) process can then be used to form metal interconnect layers for connecting the low voltage devices to other circuitry. Chemical Mechanical Polishing/Planarization (CMP) can then be used to form a smooth surface with a planar oxide layer 802. A Cu damascene process can be used for forming a Cu bonding matrix 803 with CU pads 804 for subsequent Cu-Ox hybrid bonding to another wafer.

As illustrated in Figure 15b, the method further comprises providing a second silicon wafer 805 which will become the substrate on which the micromirror array is fixed. The second wafer 805 may be referred to as the "interposer wafer". The interposer wafer 805 may be an SOI wafer with a 100 µm silicon film as seen in Figure 8b. A high voltage (HV) CMOS process (both FEOL and BEOL) may be used to form a HV driver in the wafer. A TSV process can be used to form electrical connections 806 through the silicon film 807 of the second wafer 805. The TSV process can be followed by planarization (e.g. CMP or wet etch) and Cu pad formation. The Cu pads 808 are arranged to connect to the Cu bonding matrix 803 of the first wafer 800.

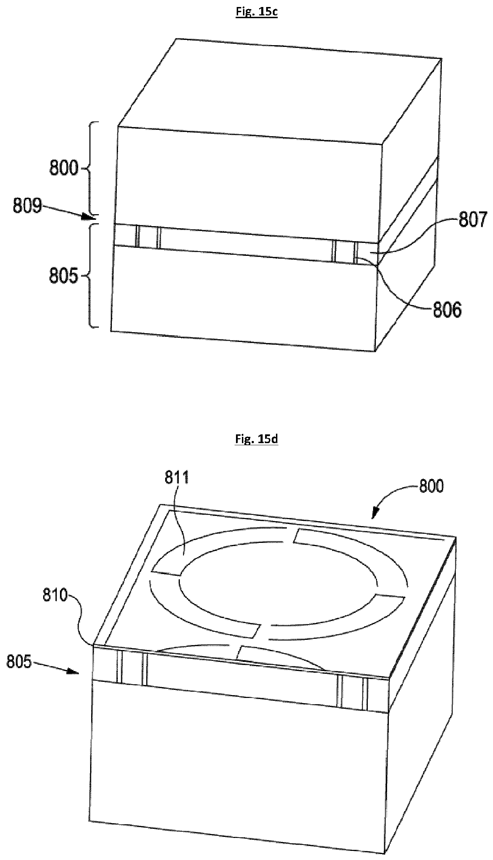

Figure 15c illustrates how the first and second wafers 800 and 805 are bonded, e.g. using a Cu/oxide hybrid bond 809.

As shown in Figure 15d, the "handle wafer" used for handling the first wafer 800 may be removed to expose the first wafer 800. Selective box removal can then be used to leave a thin layer (e.g. 5 µm) of silicon 810 of the first wafer 800 bonded to the second wafer 805. Al can be deposited and patterned on the first wafer 800 for subsequent connection to a mirror. The first wafer 800 can be patterned to form the piezoelectric actuators 811. Al₂O₃ and/or TiN can be deposited on the first wafer for protection against EUV radiation and against plasma.

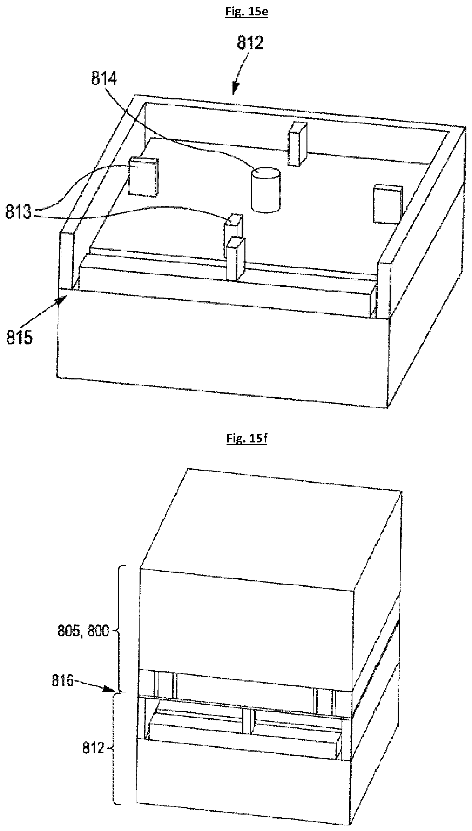

As illustrated in Figure 15e, the method further comprises providing a third silicon wafer 812 for forming the mirror. The third wafer 812 may be referred to as the "mirror wafer" 812. The mirror wafer 812 may be an SOI wafer with a 250 µm silicon film. The method may comprise performing a cavity etch on the mirror wafer 812 to allow for a thermal barrier (e.g. 1 µm to 2 µm), followed by Ge deposition for subsequent bonding to the first wafer 800. Using a hardmask (e.g. nitride) and a resist mask the mirror wafer 812 is etched to form pillars 813 ("beam connectors") for connecting to the piezoelectric actuators and to form a thermally conductive post 814 ("center post") for connecting to a heat sink so as to form a heat diffuser. A mirror release trench 815 is etched around the periphery of the mirror.

As shown in Figure 15f, the third wafer 812 is bonded to the first wafer 800 in order to connect the mirror to the piezoelectric actuators. The step of bonding may comprise aligned Ge/Al eutectic bonding. The Al/Ge bonding layer 816 is both thermally and electrically conducting, which can allow efficient heat transfer from the mirror through the thermally conductive post to the heat sink. Some of the box oxide may have been left on the first wafer 800 to reduce thermal and electrical conduction at some bonding locations such as at the pillars connected to the piezoelectric actuators.

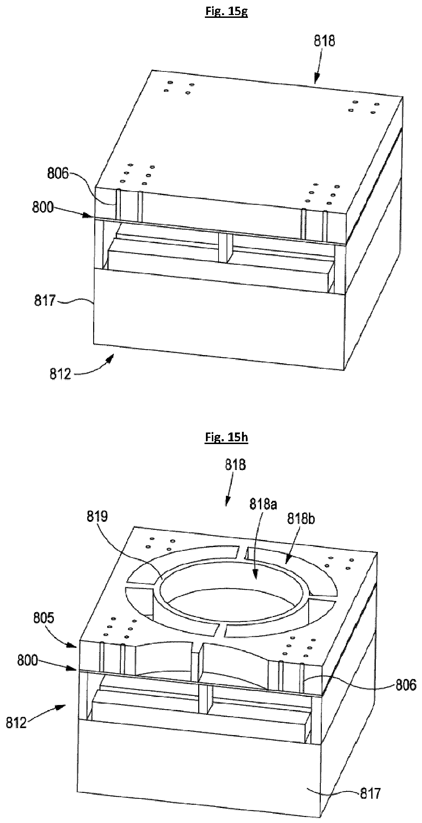

In Figure 15g, the stack of bonded wafers (wafers 1 "actuator wafer" 800, 2 "interposer wafer" 805 and 3 "mirror wafer" 812), which may collectively be referred to as the "device wafer", is turned upside down, so that the handle wafer 817 of the mirror wafer 812 becomes the supporting wafer. The handle wafer of the second wafer 805 can be removed from the second wafer 805 and box removal may be used to reveal the TSVs 806 in the second wafer 805. This can be followed by dielectric deposition, patterning and bump formation.

In Figure 15h, lithography and silicon etching is used to form cavities 818 in the second wafer 805 underneath the piezoelectric actuators and the heat sink. The flexible membrane is produced in this step. Note that in use an outer portion of the flexible membrane 314 (e.g. a portion radially outward of the grooves) is in contact with a wall 819. The wall 819 is between a cavity 818a in register with the heat sink and a cavity 818b in register with the piezoelectric actuators. The wall 819 is able conduct heat from the flexible membrane 314 to the substrate.

The flexible membrane may be etched into Z portions of different respective thicknesses as explained above with reference to Figures 4 and 5, by performing n etching steps. Here Z is an integer which is at least two, and preferably at least three. n is an positive integer (preferably greater than one), and Z is no higher than 2ⁿ. In each etching step a different respective thickness of material is removed from the flexible membrane. For example, the n steps may be labelled by j=1,...,n, and the thickness of the flexible membrane which is removed in step j may be proportional to 2^{j}. Note that these n steps may be performed in any order, i.e. increasing values of the variable j mean that a greater thickness of the flexible member is removed at the j-th step, but not that the j-th step is performed later or earlier.

For each of the Z portions, the corresponding portion of the flexible membrane is etched during a different subset of the etching steps. Thus, each of the Z portions of the flexible membrane is reduced to a different corresponding thickness.

Consider portion z, where z is an integer in the range 1 to Z. As Z is no greater than 2ⁿ, for any given value of z we can write z-1 as a binary number having n digits. The first digit of the binary value z-1 corresponds to etching step j=n; its second digit corresponds to etching step j=n-1; and so on. Thus, its n-th digit corresponds to etching step 1. According to whether any given digit is 0 or 1, the corresponding portion of the flexible membrane is respectively not etched or etched in that etching step.

For example, suppose n=3. In this case, Z may be 8. Thus, z can take any of the decimal values from 1 to 8. Equivalently, in binary, z-1 can be respectively any of 000, 001, 010, 011, 100, 101, 110, 111. Thus, the zone z=8 is etched in all three of the etching steps, because all three of the binary digits of z-1 are 1s. However, zone z=4 (for which z-1 in binary is 011) is etched in steps j=1 and j=2 (because the last two digits of 011 are both one), but not in step j=3 (because the first digit of 011 is zero).

While this illustrates that up to 2ⁿ portions of different respective thicknesses may be formed using n etching steps, note that the number of portions Z may be smaller than 2ⁿ. This is, there may be combinations of the etching steps which are not used to form any of the portions.

The area of the layer which is used to produce the central portion (z=1) of the flexible membrane is a circular area having a center which in the completed micromirror array is in register with one of the thermally conductive posts (note that optionally the part of the central portion which is in register with the post may be a different thickness from the outer part of the central portion; this part of the central portion is not considered here). Each other portion z=2,...Z, is a ring of material encircling the portion z-1.

The respective areas of the flexible membrane which are used to produce the Z portions are not all the same size. Rather, for each z, the respective radial positions (measured from the axis of the central post) of its radially-inner and radially-outer edges may such that a respective value R(z), which is the average of distances of those two edges from the center of the flexible membrane, is inversely proportional to the thickness of the portion z following the n etching steps.

The method then comprises etching a dielectric layer to reveal the piezoelectric actuators (i.e. to release the strip of flexible material), the sensing elements (piezoresistor sensor elements and/or evanescent coupling based tilt sensors and/or optical tilt sensors as shown in Figure 14) and dicing scribes.

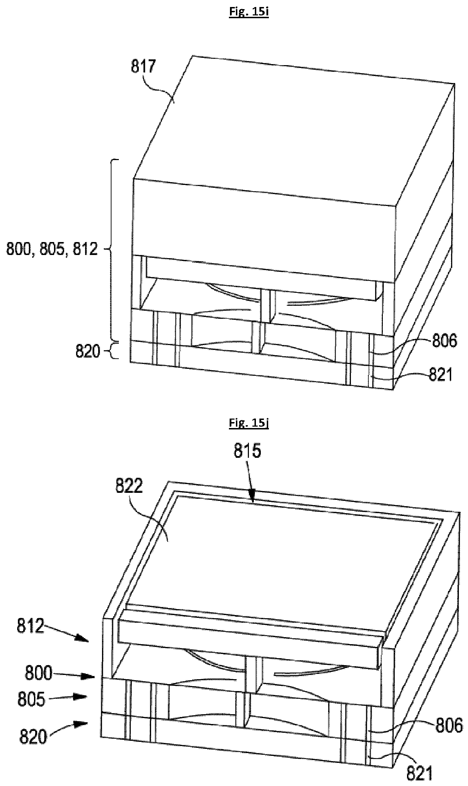

As illustrated in Figure 15i, the method further comprises providing a fourth silicon wafer 820 for sealing the second wafer 805. The fourth wafer 820 may be referred to as the "support wafer" 820 and comprises TSVs 821 for connecting to the second wafer 805. Bump bonding may be used to bond the fourth wafer 820 to the second wafer 805. An Al redistribution layer (RDL) and connection pads can be formed on the back of the fourth wafer 820.

In Figure 15j, the mirror 822 is released by removing the front side handle wafer 817. A controller chip can be glued and wirebonded to the back of the fourth wafer 820.

Another embodiment of the invention comprises a lithographic apparatus LA, such as the lithographic apparatus LA of Figure 1, configured for dark-field imaging as shown in Figure 1b. A potential problem with this configuration of dark-field imaging is that for large patterns (i.e. patterns having a large pitch between features) the diffraction angle is small, and the first order diffractions (+1 and -1) may also fall within the opening 102, which can make imaging at the wafer level difficult.

To solve this problem, the patterning device comprises a first MEMS, which can be used to displace the surface of the patterning device to direct first order diffractions from the opening 102 to the mirror 101. The MEMS comprises a plurality of MEMS elements arranged under the multilayer reflector of the patterning device MA. Each MEMs element may comprise a displacement structure (e.g. a rectangle of silicon for tipping an tilting) supporting the multilayer reflector or may be directly bonded to the underside of the multilayer reflector.

Redirecting the diffracted radiation can distort the image, and the mirror 101 therefore comprises a second MEMS (such as a micromirror array) to compensate for the redirection by correcting the angle of the patterned beam. The second MEMS may be controlled through a feedback system, which uses the position of the patterning device MA (relative to the incident radiation beam) to determine the required correction of the mirror 101 and provide control signals to the second MEMS accordingly. The second MEMS is thereby dynamically updated throughout scanning. The required corrections for a given position of the patterning device MA can be determined in advance through simulations of the particular patterning device.

The mask on the multilayer reflector may comprise both features with large pitch (e.g. pitch of the order of 100 nm or more) and small pitch (e.g. pitch < 10nm), and the first and second MEMS are configured to be used only for features having a large pitch. For the other features, the diffraction angle is large enough to avoid the opening 102 in the mirror 101.

The local deformation required for any particular area of the patterning device can be pre-set in the first MEMS, since the features of the patterning device are fixed. The patterning device may be simulated to determine the required local deformation, which can then be used to set the displacements/positions of the MEMS elements of the first MEMS.

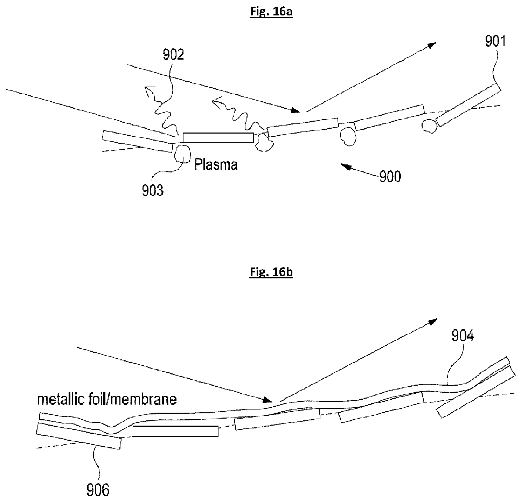

Figures 16a and 16b show embodiments of the MEMS used in a grazing incidence mirror. For normal incidence, a multilayer reflector is normally required to reflect sufficient EUV, whereas for grazing incidence a single reflective layer or coating may be used.

In Figure 16a a micromirror array 900 is used to reflect light at grazing incidence. However, the gaps between individual mirrors 901 in the array 900 can cause flares 902 from edge reflections and plasmas 903 to form.

Figure 16b shows another embodiment of the grazing incidence mirror, wherein a continuous reflective layer being a metal foil 904 is located over the displacement structures 906 of the MEMS. By displacing the displacement structure 906, the foil 904 can be deformed to redirect incident light.

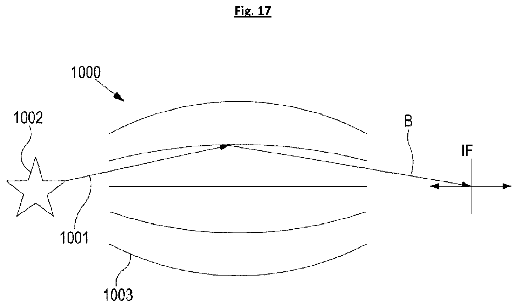

Figure 17 shows a grazing-incidence collector 1000 for collecting light 1001 from a source 1002 to form a radiation beam B. The collector 1000 comprises a plurality of cylindrical grazing incidence mirrors 1003 for focusing incident light 1001 from the source 1002 towards an intermediate focus point IF. The grazing incidence mirrors may comprise MEMS as described herein in order to control the focus point of the radiation beam B.

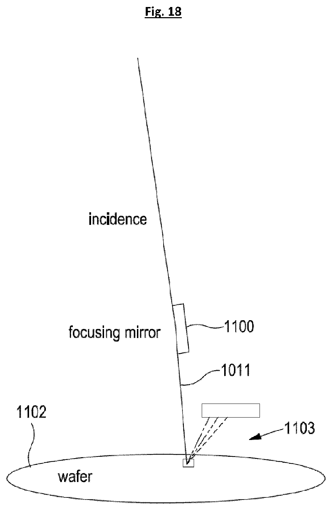

Figure 18 illustrates another embodiment of the grazing incidence mirror 1100, being a focus mirror in an inspection and/or metrology apparatus. The mirror 1100 can use the MEMS to change the point of focus of the light 1101 incident on a wafer or other substrate 1102. Light diffracted 1103 from the wafer or other substrate 1102 may be received and analyzed in order to determine features of the wafer or other substrate 1102.

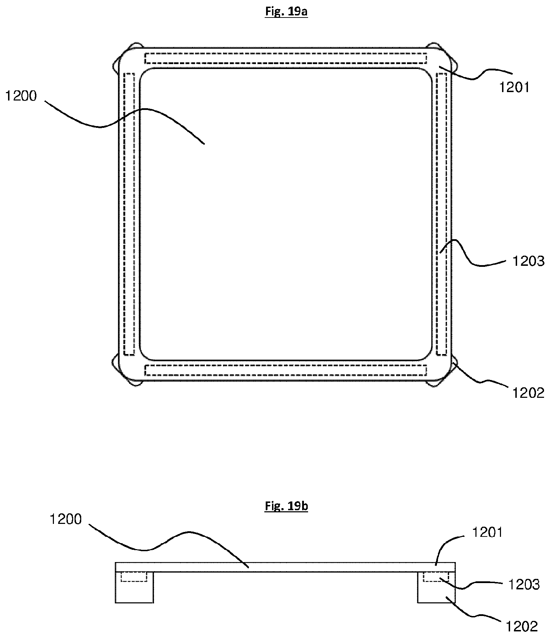

In another embodiment, the MEMS described herein is used in a pellicle frame, in order to control the stress in the pellicle over time. Figure 19a shows a top view of a pellicle 1200 with a border 1201 supported by a frame 1202. The frame comprises a MEMS 1203 with an array of MEMS elements located in the dashed regions under the border 1201. Whilst Figure 12a shows the MEMS 1203 extending under a part of the border 1201, in other embodiments the MEMS 1203 may cover the entire border 1201 of the pellicle 1200 or a different part. Figure 19b shows a side cross-section of the pellicle 1200. The MEMS 1203 is located at the top of the frame so as to contact the border 1201 of the pellicle 1200. The pellicle 1200 may be part of a mask assembly such as the mask assembly 15 of Figure 1. Active mechanical actuation from the MEMS elements is used to provide border deformation in order to apply stress to the pellicle 1200. The MEMS allows for continuous control of the pellicle border bending. A benefit of the MEMS device is that it can be controlled during operation, without requiring the mask assembly to be removed or disassembled. This means that if the pellicle film would lose, or gain, pre-stress due to a degradation process, this could be corrected for by increasing or decreasing the tilt of MEMS elements. For example, correction for a reduction of stress (which may be referred to as tension) of the pellicle 1200 may be applied by actuating the MEMS 1203 on one side, or opposite sides, of the pellicle. The actuation may move the MEMS 1203 outwards (i.e. away from an interior of the pellicle frame). Correction for a reduction of stress may be applied by actuating the MEMS 1203 on all sides of the pellicle 1200 (e.g. moving the MEMS outwards). In another example, a localized reduction of stress in the pellicle 1200 may occur (e.g. for half of the pellicle). Correction for this localized reduction of stress may be applied by actuating the MEMS 1203 on opposite sides of the area of localized stress reduction (or on one side of the area of localized stress reduction). In general, the MEMS may be actuated to correct for localized or global changes of stress of the pellicle. This may advantageously increase the lifetime of the pellicle.

In addition, the MEMS 1203 can be used to determine the level of stress in the pellicle for different areas of the pellicle. A feedback system can be used to control the MEMS elements to locally compensate for any changes in the stress. In this way automated control of the stress of the pellicle 1200 may be provided.

Full tip and tilt displacements may not be required for the pellicle, since the MEMS is only used to apply stress to the pellicle. As such, MEMS elements having tilt control in only one dimension may be used in the pellicle frame. This can simplify the fabrication and control system of the MEMS.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

## Claims

1. A micromirror array (300) comprising:
a substrate (306)
a plurality of mirrors (301) configured to reflect incident light; for each mirror of the plurality of mirrors (301), at least one actuator (302) configured to displace the mirror and connected to the substrate (306)
one or more pillars (303) connecting the mirror (301) to the at least one actuator (302); and
for each mirror of the plurality of mirrors (301), heat diffuser (314,315) configured to diffuse heat from the mirror, the heat diffuser (314,315) comprising a heat sink (314) and a thermally conductive post (315) connecting the heat sink (314) to the mirror (301), wherein
the heat sink (314) comprises a flexible membrane, which allows the thermally conductive post (315) to pivot when the mirror (301) is displaced, **characterized in that**
the flexible membrane comprises a center portion (501) and a peripheral portion (507), the center portion (501) being connected to the thermally conductive post (315) and having a thickness greater than a thickness of the peripheral portion (507).

2. A micromirror array according to claim 1, wherein the flexible membrane comprises Z portions, labelled from z = 1 to z = Z where Z is an integer greater than two, the Z portions including the center portion (z = 1), the peripheral portion (z = Z), and at least one intermediate portion, wherein
for any value of z from 1 to Z-1:
portion z + 1 encircles portion z; and
portion z + 1 has a thickness less than a thickness of portion z.

3. A micromirror array according to claim 2, wherein, for each value of z, the thickness of portion z is proportional to 1/R(z), where R(z) is an average distance of portion z from the center of the flexible membrane.

4. A micromirror array according to any one of the preceding claims, wherein the flexible membrane comprises a patterned silicon layer.

5. A micromirror array according to claim 4, wherein the flexible membrane comprises grooves through the silicon layer and extending from an outer edge of the heat diffuser towards the thermally conductive post.

6. A micromirror array according to any one of the preceding claims, wherein the one or more pillars comprise a thermally isolating layer to reduce or prevent heat transfer from the mirror to the at least one actuator.

7. A micromirror array according to any one of the preceding claims, wherein each mirror of the plurality of mirrors is for reflecting light having a wavelength of substantially 13.5 nm.

8. A micromirror array according to any one of the preceding claims, wherein the at least one actuator includes four actuators arranged so as to enable tip and tilt displacement control of the mirror.

9. A programmable illuminator comprising a micromirror array according to any one of claims 1 to 8 configured to condition a radiation beam.

10. A programmable illuminator according to claim 9 and comprising a displacement control feedback system configured to determine for each mirror of the plurality of mirrors a position of the mirror and to adjust a voltage applied to the one or more actuators based on the determined position and based on a predefined target position of the mirror.

11. A lithographic apparatus arranged to project a pattern from a patterning device onto a substrate, comprising a programmable illuminator according to claim 9 or claim 10 configured to condition a radiation beam used to illuminate the patterning device and/or configured to condition a radiation beam used to measure a target structure on the substrate.

12. An inspection and/or metrology apparatus, comprising a programmable illuminator according to claim 9 or claim 10 configured to condition a radiation beam used to measure a target structure on a substrate.

13. A method of forming a micromirror array comprising:
providing a substrate;
forming a plurality of mirrors configured to reflect incident light;
for each mirror of the plurality of mirrors, forming at least one actuator configured to displace the mirror and connected to the substrate;
forming one or more pillars connecting the mirror to the at least one actuator; and
for each mirror of the plurality of mirrors, forming a heat diffuser configured to diffuse heat from the mirror by forming a heat sink and a thermally conductive post connected to the mirror,
the forming of the heat sink comprising:
forming a flexible membrane which allows the thermally conductive post to pivot when the mirror is displaced, the flexible membrane including a center portion and a peripheral portion, the center portion being connected to the thermally conductive post and having a thickness greater than a thickness of the peripheral portion.

14. A method according to claim 13, wherein the flexible membrane comprises Z portions, from z = 1 to z = Z, where Z is an integer greater than two, the Z portions including the center portion (z = 1), the peripheral portion (z = Z), and at least one intermediate portion, wherein for any value of z from 1 to Z-1:
portion z + 1 encircles portion z; and
portion z + 1 has a thickness less than a thickness of portion z.

15. A method according to any one of claims 13 to 14, wherein the step of forming at least one actuator includes forming four actuators arranged so as to enable tip and tilt displacement control of the mirror.

## Patentansprüche

1. Ein Mikrospiegelarray (300), das Folgendes beinhaltet:
ein Substrat (306);
eine Vielzahl von Spiegeln (301), die konfiguriert sind, um einfallendes Licht zu reflektieren;
für jeden Spiegel der Vielzahl von Spiegeln (301) mindestens einen Aktor (302), der konfiguriert ist, um den Spiegel zu verlagern, und mit dem Substrat (306) verbunden ist;
einen oder mehrere Ständer (303), die den Spiegel (301) mit dem mindestens einen Aktor (302) verbinden; und
für jeden Spiegel der Vielzahl von Spiegeln (301) einen Wärmeverteiler (314, 315), der konfiguriert ist, um Wärme von dem Spiegel zu verteilen, wobei der Wärmeverteiler (314, 315) eine Wärmesenke (314) und eine thermisch leitende Säule (315), die die Wärmesenke (314) mit dem Spiegel (301) verbindet, beinhaltet, wobei
die Wärmesenke (314) eine flexible Membran beinhaltet, die das Schwenken der thermisch leitenden Säule (315) ermöglicht, wenn der Spiegel (301) verlagert wird, **dadurch gekennzeichnet, dass**
die flexible Membran einen Mittelabschnitt (501) und einen peripheren Abschnitt (507) beinhaltet, wobei der Mittelabschnitt (501) mit der thermisch leitenden Säule (315) verbunden ist und eine Dicke aufweist, die größer als eine Dicke des peripheren Abschnitts (507) ist.

2. Mikrospiegelarray gemäß Anspruch 1, wobei die flexible Membran Z Abschnitte beinhaltet, die von z = 1 bis z = Z benannt sind, wobei Z eine ganze Zahl größer als zwei ist, wobei die Z Abschnitte den Mittelabschnitt (z = 1), den peripheren Abschnitt (z = Z) und mindestens einen Zwischenabschnitt umfassen, wobei
für einen beliebigen Wert für z von 1 bis Z-1:
Abschnitt z + 1 den Abschnitt z umgibt; und
Abschnitt z + 1 eine Dicke aufweist, die kleiner als eine Dicke des Abschnitts z ist.

3. Mikrospiegelarray gemäß Anspruch 2, wobei für jeden Wert für z die Dicke des Abschnitts z proportional zu 1/R(z) ist, wobei R(z) eine durchschnittliche Entfernung des Abschnitts z von der Mitte der flexiblen Membran ist.

4. Mikrospiegelarray gemäß einem der vorhergehenden Ansprüche, wobei die flexible Membran eine gemusterte Siliciumschicht beinhaltet.

5. Mikrospiegelarray gemäß Anspruch 4, wobei die flexible Membran Rillen durch die Siliciumschicht beinhaltet und sich von einem äußeren Rand des Wärmeverteilers in Richtung der thermisch leitenden Säule erstreckt.

6. Mikrospiegelarray gemäß einem der vorhergehenden Ansprüche, wobei der eine oder die mehreren Ständer eine thermisch isolierende Schicht zum Reduzieren oder Verhindern einer Wärmeübertragung von dem Spiegel auf den mindestens einen Aktor beinhalten.

7. Mikrospiegelarray gemäß einem der vorhergehenden Ansprüche, wobei jeder Spiegel der Vielzahl von Spiegeln zum Reflektieren von Licht mit einer Wellenlänge von im Wesentlichen 13,5 nm vorgesehen ist.

8. Mikrospiegelarray gemäß einem der vorhergehenden Ansprüche, wobei der mindestens eine Aktor vier Aktoren umfasst, die so eingerichtet sind, dass sie eine Kipp- und Neigeverlagerungssteuerung des Spiegels gestatten.

9. Ein programmierbarer Beleuchter, der ein Mikrospiegelarray gemäß einem der Ansprüche 1 bis 8 beinhaltet und konfiguriert ist, um einen Strahlungsstrahl zu konditionieren.

10. Programmierbarer Beleuchter gemäß Anspruch 9, der ein Verlagerungssteuerungsrückmeldesystem beinhaltet, das konfiguriert ist, um für jeden Spiegel der Vielzahl von Spiegeln eine Position des Spiegels zu bestimmen und eine an den einen oder die mehreren Aktoren angelegte Spannung auf der Basis der bestimmten Position und auf der Basis einer vorgegebenen Zielposition des Spiegels einzustellen.

11. Ein lithographisches Gerät, das eingerichtet ist, um ein Muster von einer Musteraufbringungsvorrichtung auf ein Substrat zu projizieren, beinhaltend einen programmierbaren Beleuchter gemäß Anspruch 9 oder Anspruch 10, der konfiguriert ist, um einen zum Beleuchten der Musteraufbringungsvorrichtung verwendeten Strahlungsstrahl zu konditionieren, und/oder konfiguriert ist, um einen zum Messen einer Zielstruktur auf dem Substrat verwendeten Strahlungsstrahl zu konditionieren.

12. Ein Prüfungs- und/oder Metrologiegerät, das einen programmierbaren Beleuchter gemäß Anspruch 9 oder Anspruch 10 beinhaltet, der konfiguriert ist, um einen zum Messen einer Zielstruktur auf einem Substrat verwendeten Strahlungsstrahl zu konditionieren.

13. Ein Verfahren zum Bilden eines Mikrospiegelarrays, das Folgendes beinhaltet:
Bereitstellen eines Substrats;
Bilden einer Vielzahl von Spiegeln, die konfiguriert sind, um einfallendes Licht zu reflektieren;
für jeden Spiegel der Vielzahl von Spiegeln Bilden mindestens eines Aktors, der konfiguriert ist, um den Spiegel zu verlagern, und mit dem Substrat verbunden ist;
Bilden eines oder mehrerer Ständer, die den Spiegel mit dem mindestens einen Aktor verbinden; und
für jeden Spiegel der Vielzahl von Spiegeln Bilden eines Wärmeverteilers, der konfiguriert ist, um Wärme von dem Spiegel zu verteilen, durch Bilden einer Wärmesenke und einer thermisch leitenden Säule, die mit dem Spiegel verbunden ist,
wobei das Bilden der Wärmesenke Folgendes beinhaltet:
Bilden einer flexiblen Membran, die das Schwenken der thermisch leitenden Säule ermöglicht, wenn der Spiegel verlagert wird, wobei die flexible Membran einen Mittelabschnitt und einen peripheren Abschnitt umfasst, wobei der Mittelabschnitt mit der thermisch leitenden Säule verbunden ist und eine Dicke aufweist, die größer als eine Dicke des peripheren Abschnitts ist.

14. Verfahren gemäß Anspruch 13, wobei die flexible Membran Z Abschnitte von z = 1 bis z = Z beinhaltet, wobei Z eine ganze Zahl größer als zwei ist, wobei die Z Abschnitte den Mittelabschnitt (z = 1), den peripheren Abschnitt (z = Z) und mindestens einen Zwischenabschnitt umfassen, wobei für einen beliebigen Wert für z von 1 bis Z-1:
Abschnitt z + 1 den Abschnitt z umgibt; und
Abschnitt z + 1 eine Dicke aufweist, die kleiner als eine Dicke des Abschnitts z ist.

15. Verfahren gemäß einem der Ansprüche 13 bis 14, wobei der Schritt des Bildens mindestens eines Aktors das Bilden von vier Aktoren umfasst, die so eingerichtet sind, dass sie eine Kipp- und Neigeverlagerungssteuerung des Spiegels gestatten.

## Revendications

1. Une matrice de micromiroirs (300) comprenant :
un substrat (306) ;
une pluralité de miroirs (301) configurés pour réfléchir de la lumière incidente ;
pour chaque miroir de la pluralité de miroirs (301), au moins un actionneur (302) configuré pour déplacer le miroir et raccordé au substrat (306) ;
une ou plusieurs colonnes (303) raccordant le miroir (301) à l'au moins un actionneur (302) ; et
pour chaque miroir de la pluralité de miroirs (301), un diffuseur de chaleur (314, 315) configuré pour diffuser de la chaleur provenant du miroir, le diffuseur de chaleur (314, 315) comprenant un dissipateur de chaleur (314) et un montant thermoconducteur (315) raccordant le dissipateur de chaleur (314) au miroir (301), dans laquelle
le dissipateur de chaleur (314) comprend une membrane souple, qui permet au montant thermoconducteur (315) de pivoter lorsque le miroir (301) est déplacé, **caractérisée en ce que** la membrane souple comprend une portion centrale (501) et une portion périphérique (507), la portion centrale (501) étant raccordée au montant thermoconducteur (315) et présentant une épaisseur supérieure à une épaisseur de la portion périphérique (507).

2. Une matrice de micromiroirs selon la revendication 1, dans laquelle la membrane souple comprend Z portions, libellées de z = 1 à z = Z où Z est un entier supérieur à deux, les Z portions incluant la portion centrale (z = 1), la portion périphérique (z = Z), et au moins une portion intermédiaire, dans laquelle
pour toute valeur de z allant de 1 à Z-1 :
la portion z + 1 encercle la portion z ; et
la portion z + 1 présente une épaisseur inférieure à une épaisseur de la portion z.

3. Une matrice de micromiroirs selon la revendication 2, dans laquelle, pour chaque valeur de z, l'épaisseur de la portion z est proportionnelle à 1/R(z), où R(z) est une distance moyenne de la portion z à partir du centre de la membrane souple.

4. Une matrice de micromiroirs selon n'importe laquelle des revendications précédentes, dans laquelle la membrane souple comprend une couche de silicium à motif.

5. Une matrice de micromiroirs selon la revendication 4, dans laquelle la membrane souple comprend des rainures à travers la couche de silicium et s'étendant à partir d'un bord externe du diffuseur de chaleur en direction du montant thermoconducteur.

6. Une matrice de micromiroirs selon n'importe laquelle des revendications précédentes, dans laquelle les une ou plusieurs colonnes comprennent une couche thermo-isolante pour réduire ou empêcher un transfert de chaleur du miroir à l'au moins un actionneur.

7. Une matrice de micromiroirs selon n'importe laquelle des revendications précédentes, dans laquelle chaque miroir de la pluralité de miroirs est destiné à réfléchir de la lumière ayant une longueur d'onde de substantiellement 13,5 nm.

8. Une matrice de micromiroirs selon n'importe laquelle des revendications précédentes, dans laquelle l'au moins un actionneur inclut quatre actionneurs agencés de manière à rendre possible une commande de déplacement par basculement et inclinaison (tip et tilt) du miroir.

9. Un illuminateur programmable comprenant une matrice de micromiroirs selon n'importe laquelle des revendications 1 à 8 configuré pour conditionner un faisceau de rayonnement.

10. Un illuminateur programmable selon la revendication 9 et comprenant un système à rétroaction sur commande de déplacement configuré pour déterminer pour chaque miroir de la pluralité de miroirs une position du miroir et pour ajuster une tension appliquée aux un ou plusieurs actionneurs sur la base de la position déterminée et sur la base d'une position cible prédéfinie du miroir.

11. Un appareil lithographique agencé pour projeter un motif à partir d'un dispositif servant à conformer selon un motif sur un substrat, comprenant un illuminateur programmable selon la revendication 9 ou la revendication 10 configuré pour conditionner un faisceau de rayonnement utilisé pour illuminer le dispositif servant à conformer selon un motif et/ou configuré pour conditionner un faisceau de rayonnement utilisé pour mesurer une structure cible sur le substrat.

12. Un appareil d'inspection et/ou de métrologie, comprenant un illuminateur programmable selon la revendication 9 ou la revendication 10 configuré pour conditionner un faisceau de rayonnement utilisé pour mesurer une structure cible sur un substrat.

13. Un procédé de formation d'une matrice de micromiroirs comprenant :
la fourniture d'un substrat ;
la formation d'une pluralité de miroirs configurés pour réfléchir de la lumière incidente ;
pour chaque miroir de la pluralité de miroirs, la formation d'au moins un actionneur configuré pour déplacer le miroir et raccordé au substrat ;
la formation d'une ou de plusieurs colonnes raccordant le miroir à l'au moins un actionneur ; et
pour chaque miroir de la pluralité de miroirs, la formation d'un diffuseur de chaleur configuré pour diffuser de la chaleur provenant du miroir par formation d'un dissipateur de chaleur et d'un montant thermoconducteur raccordé au miroir,
la formation du dissipateur de chaleur comprenant :
la formation d'une membrane souple qui permet au montant thermoconducteur de pivoter lorsque le miroir est déplacé, la membrane souple incluant une portion centrale et une portion périphérique, la portion centrale étant raccordée au montant thermoconducteur et présentant une épaisseur supérieure à une épaisseur de la portion périphérique.

14. Un procédé selon la revendication 13, dans lequel la membrane souple comprend Z portions, de z = 1 à z = Z, où Z est un entier supérieur à deux, les Z portions incluant la portion centrale (z = 1), la portion périphérique (z = Z), et au moins une portion intermédiaire, dans lequel pour toute valeur de z allant de 1 à Z-1 :
la portion z + 1 encercle la portion z ; et
la portion z + 1 présente une épaisseur inférieure à une épaisseur de la portion z.

15. Un procédé selon n'importe laquelle des revendications 13 à 14, dans lequel l'étape de formation d'au moins un actionneur inclut la formation de quatre actionneurs agencés de manière à rendre possible une commande de déplacement par basculement et inclinaison (tip et tilt) du miroir.
